# EUROPEAN PATENT APPLICATION

(11) **EP 3 926 756 A1**
(43) Date of publication of application: **22.12.2021**
(21) Application number: 20755117.7
(22) Date of filing: 12.02.2020
(51) Int. Cl.: H01P 5/08, H01F 1/34, H05K 9/00, H05K 1/02, H01F 27/36

(54) **CIRCUIT SUBSTRATE, ANTENNA ELEMENT, MILLIMETER WAVE ABSORBER FOR INCORPORATION IN SUBSTRATE, AND METHOD FOR REDUCING NOISE IN CIRCUIT SUBSTRATE**

(30) Priority: 13.02.2019 JP 2019023945
(71) Applicant: The University of Tokyo, Bunkyo-ku, Tokyo 113-8654 (JP); Iwatani Corporation, Osaka 541-0053 (JP)
(72) Inventor: OHKOSHI Shin-ichi, Tokyo 113-8654 (JP); YOSHIKIYO Marie, Tokyo 113-8654 (JP); NAMAI Asuka, Tokyo 113-8654 (JP); ASANUMA Masayuki, Tokyo 113-8654 (JP); SHIBUYA Yukihiro, Tokyo 105-8458 (JP); YAMAZAKI Sumire, Tokyo 105-8458 (JP); UEDA Naomasa, Tokyo 105-8458 (JP)
(74) Representative: Bandpay & Greuter
(86) International application number: PCT/JP2020/005405
(87) International publication number: WO 2020/166628

(57) **Abstract**

Proposed are a circuit substrate, an antenna element, a built-in millimeter wave absorber for a circuit substrate, and a method for reducing noise in a circuit substrate that are capable of reducing much more noise than before in a circuit substrate. A circuit substrate 2 includes a multi-layer substrate 2b in which a plurality of dielectric layers 2e are stacked on a base substrate 2a, and shield vias V₁ to V₁₂ having an electromagnetic wave absorption peak within a region of 30 to 300 GHz and provided inside the multi-layer substrate 2b. With this structure, it is possible not only to reduce unnecessary electromagnetic waves generated inside the circuit substrate 2 simply by allowing the unnecessary electromagnetic waves to be reflected from the shield vias V₁ to V₁₂, but also to absorb the unnecessary electromagnetic waves by means of the shield vias V₁ to V₁₂, thereby reducing much more noise than before in the circuit substrate 2.

## Description

### Technical Field

The present invention relates to a circuit substrate, an antenna element, a built-in millimeter wave absorber for a circuit substrate, and a method for reducing noise in a circuit substrate.

### Background Art

Electromagnetic waves within a high frequency band including a millimeter wave band are increasingly used in various information communication systems such as mobile phones, wireless LANs, ETC systems, intelligent transport systems, driving support road systems, and satellite broadcasting. However, the growing use of electromagnetic waves within a high frequency band described above may cause deterioration in communication quality, malfunction of electronic devices, or other such failures due to interference between electronic parts.

For example, an antenna element mounted on an automotive collision-avoidance radar includes a circuit substrate having a multi-layer substrate in which a plurality of dielectric layers are stacked, and a transmitting antenna and a receiving antenna are provided on a surface of the circuit substrate (also referred to as a substrate surface). The circuit substrate includes a plurality of power feeders inside the multi-layer substrate, and the power feeders are connected to the transmitting antenna and the receiving antenna on the substrate surface.

In such an antenna element, for example, when an alternating-current voltage is applied to the power feeder connected to the transmitting antenna to transmit electromagnetic waves from the transmitting antenna, the electromagnetic waves radiated from the power feeder (hereinafter, also referred to as unnecessary electromagnetic waves) spread in the circuit substrate. As a result, a transmission signal is mixed into a received signal and behaves like noise, which leads to deterioration in communication quality.

To cope with such a problem, a technique for suppressing the unnecessary electromagnetic waves is proposed in which a plurality of pillar-shaped metal vias (hereinafter, also referred to as metal shield vias) are provided at a predetermined interval to surround the power feeder that is a generation source of the unnecessary electromagnetic waves in the circuit substrate. The plurality of metal shield vias function as reflection walls of the electromagnetic waves, which makes it possible to suppress the unnecessary electromagnetic waves diffused from the power feeder in the circuit substrate (for example, refer to Patent Literature 1) .

### Citation List

### Patent Literature

Patent Literature 1: Japanese Patent No. 4535995

### Summary of Invention

### Technical Problem

However, even if such metal shield vias are provided in the circuit substrate, the unnecessary electromagnetic waves diffused from the power feeder are reflected from the metal shield vias, and thus, the reflected unnecessary electromagnetic waves may be returned to the transmitting antenna or the receiving antenna, behaving like noise.

When the electromagnetic waves are transmitted from the transmitting antenna, the electromagnetic waves around the transmitting antenna may also be diffused as unnecessary electromagnetic waves into the circuit substrate or the like, which results in degradation in directivity of the transmitting antenna or the receiving antenna in some cases.

For this reason, there is a need to develop a circuit substrate that is capable of further suppressing the unnecessary electromagnetic waves generated in the circuit substrate, thereby reducing noise in the circuit substrate.

The present invention has been made in view of the foregoing, and an object of the present invention is to provide a circuit substrate, an antenna element, a built-in millimeter wave absorber for a circuit substrate, and a method for reducing noise in a circuit substrate that are capable of reducing much more noise than before in a circuit substrate.

### Solution to Problem

In order to solve the problem, a circuit substrate according to the present invention includes a multi-layer substrate in which a plurality of dielectric layers are stacked, and a millimeter wave absorber provided inside the multi-layer substrate and having an electromagnetic wave absorption peak within a region of 30 to 300 GHz.

An antenna element of the present invention includes the circuit substrate described above, a power feeder provided inside the multi-layer substrate of the circuit substrate, and an antenna provided on a surface of the circuit substrate and connected to the power feeder.

A built-in millimeter wave absorber for a circuit substrate of the present invention is provided inside a multi-layer substrate in which a plurality of dielectric layers are stacked. The built-in millimeter wave absorber has an electromagnetic wave absorption peak within a region of 30 to 300 GHz.

A method for reducing noise in a circuit substrate is a method for reducing noise in a circuit substrate including a multi-layer substrate in which a plurality of dielectric layers are stacked. The method includes, by a millimeter wave absorber provided inside the multi-layer substrate and having an electromagnetic wave absorption peak within a region of 30 to 300 GHz, absorbing unnecessary electromagnetic waves diffused in the multi-layer substrate to reduce noise in the circuit substrate.

### Advantageous Effects of Invention

According to the present invention, unnecessary electromagnetic waves generated inside a circuit substrate can be absorbed by a millimeter wave absorber, which leads to a much more reduction in noise than before in the circuit substrate.

### Brief Description of Drawings

Fig. 1A is a schematic sectional side view illustrating a configuration of an antenna element according to the present invention.
Fig. 1B is a schematic top cross-sectional view illustrating a configuration of shield vias provided around a power feeder for transmission.
Fig. 2 is a schematic view illustrating a configuration of shield vias provided inside a multi-layer substrate.
Fig. 3 is a schematic top view of the multi-layer substrate shown in Fig. 2, illustrating a layout of the power feeder for transmission and the shield vias.
Fig. 4A is a schematic sectional view illustrating a configuration of the shield via of the present invention.
Fig. 4B is a schematic sectional view illustrating a configuration of a metal-wall shield via.
Fig. 4C is a schematic sectional view illustrating a configuration of a conventional metal shield via.
Fig. 4D is a schematic view illustrating a configuration in which the metal-wall shield vias are optimally provided in the multi-layer substrate shown in Fig. 3.
Fig. 5A is a schematic view of a step of forming a through hole in the multi-layer substrate.
Fig. 5B is a schematic view of a step of a metal plating process.
Fig. 5C is a schematic view of a step of providing a silk screen plate.
Fig. 6A is a schematic view of a step of forming a metal plating layer on an inner circumferential wall of the through hole.
Fig. 6B is a schematic view of a step of forming a metal wall on the inner circumferential wall of the through hole.
Fig. 6C is a schematic view of a step of forming a pillar portion, made of an electromagnetic wave absorption material, in the through hole of the multi-layer substrate.
Fig. 7 is a graph showing a time waveform (1) of a pulsed wave used for a simulation.
Fig. 8A is an image showing an electromagnetic field analysis result of performing a simulation test by an FDTD method in a comparative example.
Fig. 8B is an image showing an electromagnetic field analysis result of performing the simulation test by the FDTD method in Example 1.
Fig. 8C is an image showing an electromagnetic field analysis result of performing the simulation test by the FDTD method in Example 2.
Fig. 9 is a table of measurement results of measuring electric field intensities at five measurement locations based on the analysis results of Fig. 8A, Fig. 8B, and Fig. 8C.
Fig. 10A shows images (1) of time dependence of the electric field intensity during the simulation test by the FDTD method in the comparative example.
Fig. 10B shows images (1) of the time dependence of the electric field intensity during the simulation test by the FDTD method in Example 1.
Fig. 10C shows images (1) of the time dependence of the electric field intensity during the simulation test by the FDTD method in Example 2.
Fig. 11A shows images (2) of the time dependence of the electric field intensity during the simulation test by the FDTD method in the comparative example.
Fig. 11B shows an image (2) of the time dependence of the electric field intensity during the simulation test by the FDTD method in Example 1.
Fig. 11C shows an image (2) of the time dependence of the electric field intensity during the simulation test by the FDTD method in Example 2.
Fig. 12 shows measurement locations for measuring the electric field intensities on the image of the analysis results of performing the simulation test by the FDTD method.
Fig. 13A is a table of results of measuring the electric field intensities in chronological order in the comparative example at the three measurement locations shown in Fig. 12.
Fig. 13B is a table of results of measuring the electric field intensities in chronological order in Example 1 at the three measurement locations shown in Fig. 12.
Fig. 13C is a table of results of measuring the electric field intensities in chronological order in Example 2 at the three measurement locations shown in Fig. 12.
Fig. 14A is a schematic view illustrating a configuration of a shield via (1) of another embodiment.
Fig. 14B is a schematic view illustrating a configuration of a shield via (2) of still another embodiment.
Fig. 14C is a schematic view illustrating a configuration of a shield via (3) of still another embodiment.
Fig. 15 is a schematic view illustrating a configuration of other shield vias provided in a multi-layer substrate.
Fig. 16 is a schematic view illustrating an example of a shield layer of still another embodiment.
Fig. 17 is a schematic view illustrating a configuration of a metal-wall unit provided inside a multi-layer substrate.
Fig. 18A is a schematic top view illustrating a configuration of the multi-layer substrate shown in Fig. 17.
Fig. 18B shows graphs of a time waveform (2) and frequency dependence of a pulsed wave used for a simulation.
Fig. 19 shows images of electromagnetic field analysis results of performing the simulation test by the FDTD method in Comparative Example 1, Comparative Example 2, and Example 3.
Fig. 20 is a table of measurement results of measuring the electric field intensities in Comparative Example 1, Comparative Example 2, and Example 3 at three measurement locations shown in Fig. 19.
Fig. 21A shows images of the time dependence of the electric field intensity during the simulation test by the FDTD method in Comparative Example 2.
Fig. 21B shows images of the time dependence of the electric field intensity during the simulation test by the FDTD method in Example 3.
Fig. 22 is a schematic view illustrating a configuration in which metal-wall units facing each other are provided in a multi-layer substrate including a receive port and a transmit port.
Fig. 23A shows images of the time dependence of the electric field intensity during the simulation test by the FDTD method performed on the multi-layer substrate including the receive port and the transmit port.
Fig. 23B shows images of the time dependence of the electric field intensity during the simulation test by the FDTD method performed for the configuration in which the metal-wall units facing each other are provided inside the multi-layer substrate shown in Fig. 23A.
Fig. 24A is a schematic view illustrating a configuration of metal-wall units (1) according to still another embodiment.
Fig. 24B is a schematic view illustrating a configuration of metal-wall units (2) according to still another embodiment.

### Description of Embodiments

Hereinafter, embodiments of the present invention will be described in detail with reference to the drawings.

### (1) <Outline of Antenna Element of Invention>

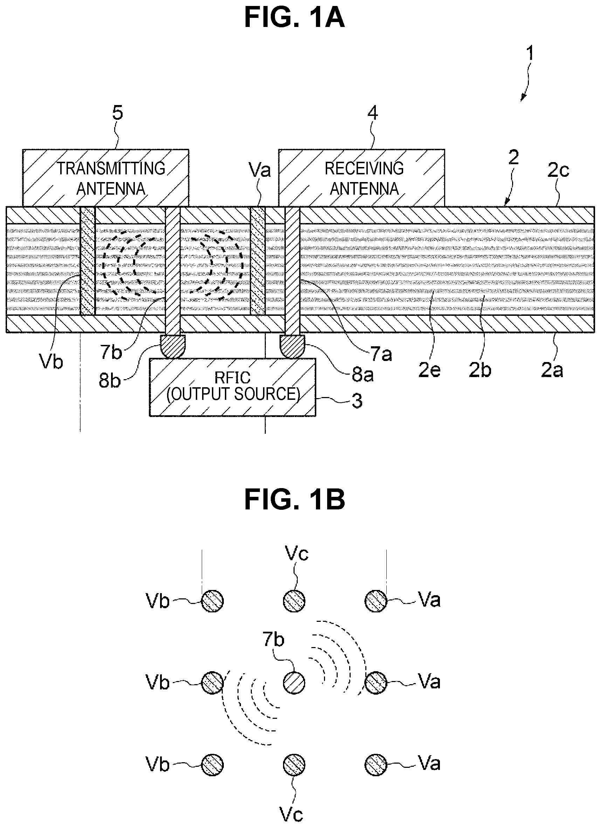

Fig. 1A is a schematic sectional side view illustrating a configuration of an antenna element 1 of the present invention. The antenna element 1 includes a circuit substrate 2, a radio frequency integrated circuit (RFIC) 3, a receiving antenna 4, and a transmitting antenna 5. In the circuit substrate 2 of the embodiment, for example, a multi-layer substrate 2b such as a printed circuit board is provided on a base substrate 2a, and a radio frequency (RF) substrate 2c is provided on the multi-layer substrate 2b. The multi-layer substrate 2b includes a plurality of dielectric layers 2e which are stacked one above the other.

The material of the base substrate 2a is not particularly limited, but it might be preferable to employ a circuit substrate in which a dielectric plate with a low dielectric loss and a conductive foil with a high electroconductivity are alternately stacked in order to suppress the attenuation of a high frequency wave signal. However, the type of conductor is not particularly limited without interfering with the object of the present invention, but preferably limited to metal. Preferred examples of such a metal include aluminum, titanium, SUS, copper, brass, silver, gold, and platinum.

In the circuit substrate 2, the receiving antenna 4 and the transmitting antenna 5 are provided as an antenna on the surface of the RF substrate 2c. The radio frequency integrated circuit 3 is electrically connected to the receiving antenna 4 and the transmitting antenna 5 through signal vias (a power feeder 7a for reception and a power feeder 7b for transmission), and is provided on the surface of the base substrate 2a.

In the antenna element 1, a dielectric substance used as the material of the dielectric layer 2e is appropriately selected from various dielectric substances that are used for the purpose of insulation or the like. Preferred examples of such a dielectric substance include PTFE and a glass fiber-containing epoxy resin. Each dielectric layer 2e is provided with a plurality of circuit groups with different frequency bands and different signal processing methods, such as a power circuit for RFIC, a digital circuit, and an analog circuit for a baseband signal.

In the embodiment, the power feeder 7a for reception and the power feeder 7b for transmission are provided as signal vias inside the circuit substrate 2 so as to penetrate through the base substrate 2a, the multi-layer substrate 2b, and the RF substrate 2c in a thickness direction of these substrate. The power feeder 7a for reception has one end connected to the receiving antenna 4, and the other end connected to the radio frequency integrated circuit 3 through a joint portion 8a. When the receiving antenna 4 receives an electromagnetic wave in a millimeter wave region, the receiving antenna 4 outputs a received signal to the radio frequency integrated circuit 3.

The power feeder 7b for transmission has one end connected to the transmitting antenna 5, and the other end connected to the radio frequency integrated circuit 3 through a joint portion 8b, and outputs a transmission signal in a millimeter wave region that is generated by the radio frequency integrated circuit 3 to the transmitting antenna 5. Accordingly, the transmitting antenna 5 transmits the electromagnetic wave in the millimeter wave region toward the outside. Here, the millimeter wave region in the embodiment indicates a region of 30 to 300 GHz, and the receiving antenna 4 and the transmitting antenna 5 according to the embodiment are capable of receiving and transmitting an electromagnetic wave having an electric wave peak within a region of 30 to 300 GHz (the millimeter wave region).

In addition to such a configuration, the circuit substrate 2 includes therein column-shaped shield vias Va and Vb as millimeter wave absorbers. In the embodiment, the shield vias Va and Vb are provided inside the circuit substrate 2 so as to penetrate through the multi-layer substrate 2b and the RF substrate 2c such that the thickness direction of the circuit substrate 2 is parallel to an axis direction of the shield vias Va and Vb. The shield vias Va and Vb are disposed parallel to the power feeder 7b for transmission.

Here, Fig. 1B is a schematic top cross-sectional view illustrating a configuration of shield vias Va, Vb, and Vc provided around the power feeder 7b for transmission. As shown in Fig. 1B, the shield vias Va, Vb, and Vc having the same configuration are separated from the power feeder 7b for transmission by a predetermined distance so as to surround the power feeder 7b for transmission. The shield vias Va, Vb, and Vc have an electromagnetic wave absorption peak, at which the electromagnetic wave absorption is maximum, within a region of 30 to 300 GHz in accordance with the millimeter wave region used for the antenna element 1, and are able to absorb an unnecessary electromagnetic wave generated inside the circuit substrate 2.

Here, the unnecessary electromagnetic wave is an electromagnetic wave within a region of 30 to 300 GHz that is diffused in the circuit substrate 2 from the power feeder 7b for transmission by an alternating-current voltage applied to the power feeder 7b for transmission from the radio frequency integrated circuit 3 when the electromagnetic wave having an electric wave peak within a region of 30 to 300 GHz is transmitted from the transmitting antenna 5.

As described above, the unnecessary electromagnetic wave diffused in the circuit substrate 2 is an unintended electromagnetic wave and may affect other electronic parts such as the receiving antenna 4. In order to address such a situation, Patent Literature 1 discloses that a metal shield via is provided as a reflection wall of an electromagnetic wave in a circuit substrate, and an unnecessary electromagnetic wave diffused in the circuit substrate is reflected from and attenuated by the metal shield via, thereby suppressing the unnecessary electromagnetic wave.

However, the inventors found that even if such a conventional metal shield via is provided inside the circuit substrate, the unnecessary electromagnetic wave that is diffused from the power feeder 7b for transmission in the circuit substrate remains as a standing wave in the circuit substrate for a given period of time after being reflected from the metal shield via or the like. For example, while electromagnetic waves are continuously transmitted from the transmitting antenna 5, if the unnecessary electromagnetic wave remains as a standing wave in the circuit substrate, the unnecessary electromagnetic wave affects the transmitting antenna 5 or other electronic parts, which may lead to noise generation. For this reason, it is desirable that the unnecessary electromagnetic wave generated in the circuit substrate should be reduced in a short period of time.

Therefore, in the embodiment, the shield vias Va, Vb, and Vc are provided not only for a reflection wall of the electromagnetic wave, but also for absorbing a millimeter wave by a natural resonance. The natural resonance is generated in the shield vias Va, Vb, and Vc in a millimeter wave region of the unnecessary electromagnetic wave when the unnecessary electromagnetic wave is diffused in the circuit substrate 2. Accordingly, the unnecessary electromagnetic wave can be prevented from remaining as a standing wave in the circuit substrate 2, and the unnecessary electromagnetic wave diffused in the circuit substrate 2 can be reduced in a short period of time.

As described above, the unnecessary electromagnetic wave diffused in the circuit substrate 2 can be reduced in a short period of time. Therefore, even when electromagnetic waves are continuously transmitted from the transmitting antenna 5, the intensity of the unnecessary electromagnetic wave can be decreased in a short period of time between transmission of one electromagnetic wave by the transmitting antenna 5 and transmission of next electromagnetic wave by the transmitting antenna 5.

In the embodiment, the shield via Va is provided between the power feeder 7a for reception and the power feeder 7b for transmission, and absorbs an unnecessary electromagnetic wave diffused from the power feeder 7b for transmission toward the adjacent power feeder 7a for reception or an unnecessary electromagnetic wave reflected from others, for example. In addition, the shield via Vb is located on the opposite side of the power feeder 7b for transmission from the shield via Va, and absorbs an unnecessary electromagnetic wave diffused from the power feeder 7a for reception or an unnecessary electromagnetic wave reflected from others, for example. Further, the shield via Vc is provided between the shield vias Va and Vb and absorbs an unnecessary electromagnetic wave diffused from the power feeder 7b for transmission or an unnecessary electromagnetic wave reflected from others.

In the embodiment, a diameter of a circular cross section of the shield vias Va, Vb, and Vc (hereinafter, referred to as a via diameter) is several hundred µm (the diameter of 100 to 200 µm is particularly desirable in 79 GHz band), an interval between the shield vias Va, Vb, and Vc (hereinafter, referred to as a via interval) is approximately 400 µm (the interval of less than 1/4 of an electromagnetic wave propagation wavelength in the circuit substrate 2 is particularly desirable). It is desirable that such a via diameter and via interval should be selected in accordance with the millimeter wave region of the unnecessary electromagnetic wave or the like.

### (2) <Shield Via>

Next, reference will be made to the shield vias Va, Vb, and Vc described above. An electromagnetic wave absorption material of the shield vias Va, Vb, and Vc is not particularly limited as long as the material has an electromagnetic wave absorption peak within a region of 30 to 300 GHz, but it is particularly preferable to employ epsilon-type iron oxide as the electromagnetic wave absorption material. The shield vias Va, Vb, and Vc are able to have an electromagnetic wave absorption peak within a region of 30 to 300 GHz, for example, depending on material composition.

### (2-1) <Epsilon-Type Iron Oxide>

Next, reference will be made below to epsilon-type iron oxide that is used as the electromagnetic wave absorption material of the shield vias Va, Vb, and Vc. The shield vias Va, Vb, and Vc as a millimeter wave absorber and a built-in millimeter wave absorber for a circuit substrate have the same configuration, and thus, the following explanation will focus on the shield via Va.

It is desirable that the epsilon-type iron oxide should be any crystals represented by formulae ε-Fe₂O₃, ε-AₓFe₂₋ₓO₃ (where A is an element other than Fe, and x is in a range of 0 < x < 2), ε-B_{y}C_{z}Fe_{2-y-z}O₃ (where B and C are elements other than A and Fe and different from each other, y is in a range of 0 < y < 1, and z is in a range of 0 < z < 1), and ε-D_{U}E_{V}F_{W}Fe_{2-U-V-W}O₃ (where D, E, and F are elements other than A and Fe and different from each other, U is in a range of 0 < U < 1, V is in a range of 0 < V < 1, and W is in a range of 0 < W < 1) .

ε-AₓFe₂₋ₓO₃ has the same crystalline system and space group as those of ε-Fe₂O₃, and a part of Fe sites in ε-Fe₂O₃ crystal is substituted by an element A other than Fe to obtain ε-AₓFe₂₋ₓO₃. In order to stabilize the crystal structure of ε-Fe₂O₃, the element A is preferably a trivalent element. For example, the element A is one element selected from Al, Sc, Ti, V, Cr, Ga, In, Y, and Rh.

Among them, In, Ga, Al, and Rh are preferable as the element A. In a case where the element A is Al, in a composition represented by ε-AₓFe₂₋ₓO₃, x is preferably in a range of, for example, 0 or more and less than 0.8. In a case where the element A is Ga, x is preferably in a range of, for example, 0 or more and less than 0.8. In a case where the element A is In, x is preferably in a range of, for example, 0 or more and less than 0.3. In a case where the element M is Rh, x is preferably in a range of, for example, 0 or more and less than 0.3.

ε-B_{y}C_{z}Fe_{2-y-z}O₃ has the same crystalline system and space group as those of ε-Fe₂O₃, and a part of Fe sites in ε-Fe₂O₃ crystal is substituted by two elements B and C other than Fe to obtain ε-B_{y}C_{z}Fe_{2-y-z}O₃. In order to stabilize the crystal structure of ε-Fe₂O₃, the element B is preferably a tetravalent element, and the element C is preferably a divalent element. For example, the element B is Ti, and the element C is one element selected from Co, Ni, Mn, Cu, and Zn.

ε-D_{U}E_{V}F_{W}Fe_{2-U-V-W}O₃ has the same crystalline system and space group as those of ε-Fe₂O₃, and a part of Fe sites in ε-Fe₂O₃ crystal is substituted by three elements D, E, and F other than Fe to obtain ε-D_{U}E_{V}F_{W}Fe_{2-U-V-W}O₃. In order to stabilize the crystal structure of ε-Fe₂O₃, the element D is preferably a trivalent element, the element E is preferably a tetravalent element, and the element F is preferably a divalent element. For example, the element D is one element selected from Al, Sc, Ti, V, Cr, Ga, In, Y, and Rh, the element E is Ti, and the element F is one element selected from Co, Ni, Mn, Cu, and Zn.

Fe is excluded from the elements A, B, C, D, E, and F described above in order to substitute a part of Fe³⁺ ion sites in ε-Fe₂O₃ by one element, or two or three elements different from each other. Here, a particle size of the epsilon-type iron oxide is not particularly limited. For example, an average particle size measured from a transmission electron microscope (TEM) picture is desirably in a range of 5 to 200 nm, more desirably 100 nm or less, even more desirably 50 nm or less, and still more desirably 20 nm or less.

In a case where the epsilon-type iron oxide described above is employed as the electromagnetic wave absorption material in the shield via Va, it is possible to obtain the shield via Va having the electromagnetic wave absorption peak within a region of, for example, 30 to 300 GHz, preferably, within a region of 35 to 270 GHz. The frequency which yields the maximum electromagnetic wave absorption can be controlled by adjusting at least one of the types and a substitution amount of the elements A, B, C, D, E, and F described above.

Here, a coercive force Hc of the epsilon-type iron oxide varies depending on the substitution amount by the substitution elements A, B, C, D, E, and F described above. In other words, by adjusting the substitution amount by the substitution elements A, B, C, D, E, and F in the epsilon-type iron oxide, the coercive force Hc of the epsilon-type iron oxide can be adjusted.

Specifically, in a case where Al, Ga, or the like is used as the substitution element A in a composition represented by ε-AₓFe₂₋ₓO₃, the coercive force Hc of the epsilon-type iron oxide decreases as the substitution amount increases. On the other hand, in a case where Rh or the like is used as the substitution element A, the coercive force Hc of the epsilon-type iron oxide increases as the substitution amount increases.

Ga, Al, In, and Rh are preferably employed as the substitution element A from the viewpoint of easy adjustment of the coercive force Hc of the epsilon-type iron oxide in accordance with the substitution amount by the substitution element A. With a decrease in the coercive force Hc, the frequency which yields the electromagnetic wave absorption peak in the epsilon-type iron oxide is shifted to a low frequency side or high frequency side. That is, the frequency which yields the electromagnetic wave absorption peak can be controlled in accordance with the substitution amount by the substitution element A.

A metal oxide magnetic material that is commonly used for the electromagnetic wave absorbers shows a small magnetic anisotropy, and thus, is not capable of absorbing electromagnetic waves of a high frequency, such as a millimeter wave. In contrast, the epsilon-type iron oxide described above shows a large magnetic anisotropy, and exhibits a natural resonance frequency of 182 GHz, for example, and thus, is capable of absorbing electromagnetic waves of a frequency that is about three times as high as that of the existing metal oxide magnetic material.

In a case of commonly used metal oxide magnetic material, the absorption amount becomes almost zero if an incident angle or frequency of electromagnetic waves is out of an expected range. In contrast, in a case of using the epsilon-type iron oxide, the electromagnetic wave absorption is exhibited in a broad range of frequency bands and electromagnetic wave incident angles even if the incident angle or the frequency is slightly out of the expected range. In view of this, the present invention is able to provide the shield via Va that is capable of absorbing electromagnetic waves in a broad frequency band.

The epsilon-type iron oxide is a known material. The epsilon-type iron oxide is any one of crystals ε-AₓFe₂₋ₓO₃, ε-B_{y}C_{z}Fe_{2-y-z}O₃, and ε-D_{U}E_{V}F_{W}Fe_{2-U-V-W}O_{3.} ε-AₓFe₂₋ₓO₃ is obtained by substituting a part of Fe sites in ε-Fe₂O₃ by the element A other than Fe, ε-B_{y}C_{z}Fe_{2-y-z}O₃ is obtained by substituting a part of Fe sites in ε-Fe₂O₃ by the elements B and C other than Fe, and ε-D_{U}E_{V}F_{W}Fe_{2-U-V-W}O₃ is obtained by substituting a part of Fe sites in ε-Fe₂O₃ by the elements D, E, and F other than Fe. Such an epsilon-type iron oxide can be synthesized by, for example, a combined process of a reverse micelle method and a sol-gel method, as well as a calcination process. In addition, as disclosed in JP-A-2008-174405, the epsilon-type iron oxide can also be synthesized by a combined process of a direct synthesis method and a sol-gel method, as well as a calcination process.

A more detailed manufacturing method is disclosed in the following prior art references, for example, and thus, the explanation thereof will be omitted here: "Jian Jin, Shinichi Ohkoshi and Kazuhito Hashimoto, ADVANCED MATERIALS 2004, 16, No. 1, January 5, p. 48-51" and "Shin-ichi Ohkoshi, Shunsuke Sakurai, Jian Jin, Kazuhito Hashimoto, JOURNAL OF APPLIED PHYSICS, 97, 10K312 (2005)."

The content of epsilon-type iron oxide in the material of the shield via Va is not particularly limited without interfering with the object of the present invention. Typically, the content of epsilon-type iron oxide is preferably 30% or more by mass, more preferably 40% or more by mass, particularly preferably 60% or more by mass, and most preferably 60 to 91% by mass, with respect to the mass of the material of the shield via Va.

### (2-2) <Relative Permittivity Adjustment Method>

Relative permittivity of the shield via Va containing the epsilon-type iron oxide is 1 to 150, preferably 1 to 100, and more preferably 1 to 90. A method of adjusting the relative permittivity of the shield via Va is not particularly limited. Examples of a method of adjusting the relative permittivity of the shield via Va include a method of adding a dielectric material (which is a magnetic material for adjusting relative permittivity) as a material of the shield via Va while adjusting the content of the dielectric material.

Preferred examples of the dielectric material include barium titanate, strontium titanate, calcium titanate, magnesium titanate, bismuth titanate, zirconium titanate, zinc titanate, and titanium dioxide. The shield via Va may contain a combination of a plurality of types of dielectric materials.

In a case of adjusting the relative permittivity of the shield via Va using the dielectric material, the amount of the dielectric material is not particularly limited as long as the relative permittivity of the shield via Va is in a predetermined range. Typically, the amount of the dielectric material is preferably 0 to 20% by mass, and more preferably 5 to 10% by mass, with respect to the mass of the materials of the shield via Va.

The relative permittivity of the shield via Va can be adjusted by adding carbon nanotube to the shield via Va. From the viewpoint of easily obtaining the shield via Va which is excellent in electromagnetic wave absorbing performance, it is preferable that the shield via Va should contain carbon nanotube. The carbon nanotube may be used together with a powder of the dielectric material described above.

The amount of carbon nanotube in the materials of the shield via Va is not particularly limited as long as the relative permittivity of the shield via Va is in the predetermined range described above. However, since carbon nanotube is a conductive material, an excessive amount of carbon nanotube may deteriorate the electromagnetic wave absorbing properties exhibited by the shield via Va.

Typically, the amount of carbon nanotube is preferably 0 to 20% by mass, and more preferably 1 to 10% by mass, with respect to the mass of the materials of the shield via Va.

### (2-3) <Relative Magnetic Permeability Adjustment Method>

Relative magnetic permeability of the shield via Va is not particularly limited, but is preferably 1.0 to 2.0. A method of adjusting the relative magnetic permeability of the shield via Va is not particularly limited. Examples of a method of adjusting the relative magnetic permeability of the shield via Va include a method of adjusting the selection of the substitution elements A, B, C, D, E, and F in the epsilon-type iron oxide as a magnetically permeable material (which is a magnetic material for adjusting relative magnetic permeability), a method of adjusting the substitution amounts by the substitution elements A, B, C, D, E, and F as described above, and a method of adjusting the content of the epsilon-type iron oxide in the shield via Va.

In addition to epsilon-type iron oxide, examples of the magnetic material for adjusting the relative magnetic permeability include hexagonal ferrite such as Sr ferrite and Ba ferrite, and its metal substitute (also including a plurality of metal substitutes), spinel ferrite such as Co ferrite, magnetite, manganese zinc ferrite, nickel zinc ferrite, and copper zinc ferrite, and its metal substitute (also including a plurality of metal substitutes), garnet ferrite such as yttrium iron garnet, and its metal substitute (also including a plurality of metal substitutes), and a magnetic alloy such as FePt, CoPt, and FePd, and its metal substitute (also including a plurality of metal substitutes) .

### (2-4) <Polymer>

In order to facilitate a uniform dispersion of the epsilon-type iron oxide and the like in the shield via Va, the shield via Va may contain a polymer. In a case where the shield via Va contains a polymer, a component such as epsilon-type iron oxide can be easily dispersed in a matrix composed of the polymer.

The type of polymer is not particularly limited without interfering with the object of the present invention as long as it allows the formation of a pillar-shaped shield via Va. The polymer may be an elastic material such as elastomer or rubber. In addition, the polymer may be a thermoplastic resin or a curable resin. In a case where the polymer is a curable resin, the curable resin may be a photosetting resin or a thermosetting resin.

Preferred examples of the polymer being a thermoplastic resin include polyacetal resin, polyamide resin, polycarbonate resin, polyester resin (polybutylene terephthalate, polyethylene terephthalate, polyarylate, and the like), FR-AS resin, FR-ABS resin, AS resin, ABS resin, polyphenylene oxide resin, polyphenylene sulfide resin, polysulfone resin, polyethersulfone resin, polyetheretherketone resin, fluorine-based resin, polyimide resin, polyamideimide resin, polyamide bismaleimide resin, polyetherimide resin, polybenzoxazole resin, polybenzothiazole resin, polybenzimidazole resin, BT resin, polymethylpentene, ultra-high molecular weight polyethylene, FR-polypropylene, cellulose resin, (meth)acrylic resin (polymethylmethacrylate and the like), and polystyrene.

Preferred examples of the polymer being a thermosetting resin include phenolic resin, melamine resin, epoxy resin, and alkyd resin. As a photosetting resin, a resin obtained by photosetting of various vinyl monomers or various monomers having an unsaturated bond such as (meth) acrylic ester can be used.

Preferred examples of the polymer being an elastic material include olefin-based elastomer, styrene-based elastomer, polyamide-based elastomer, polyester-based elastomer, and polyurethane-based elastomer.

In a case where the shield via Va is formed by using a paste described later, the paste may contain a dispersion medium and a polymer. In this case, from the viewpoint of facilitating a uniform dispersion of epsilon-type iron oxide and the like in the polymer, it is preferable that the polymer should be soluble in the dispersion medium.

In a case where the materials of the shield via Va contain a polymer, the content of the polymer is not particularly limited without interfering with the object of the present invention. Typically, the content of the polymer is preferably 5 to 30% by mass, and more preferably 10 to 25% by mass, with respect to the mass of the materials of the shield via Va.

### (2-5) <Dispersant>

The shield via Va may contain a dispersant in order to successfully disperse epsilon-type iron oxide and substances added for adjusting relative permittivity and relative magnetic permeability in the shield via Va. A method of blending the dispersant into the materials of the shield via Va is not particularly limited. The dispersant may be uniformly mixed together with the epsilon-type iron oxide or a polymer. In a case where the materials of the shield via Va contain a polymer, the dispersant may be blended in with the polymer. Alternatively, the epsilon-type iron oxide and the substances added for adjusting the relative permittivity and the relative magnetic permeability which are treated with the dispersant in advance may be blended together for the shield via Va.

The type of dispersant is not particularly limited without interfering with the object of the present invention. The dispersant can be selected from various dispersants conventionally used for dispersion of various inorganic particulates and organic particulates.

Preferred examples of the dispersant include a silane coupling agent, a titanate coupling agent, a zirconate coupling agent, and an aluminate coupling agent.

The content of the dispersant is not particularly limited without interfering with the object of the present invention. The content of the dispersant is preferably 0.1 to 30% by mass, more preferably 1 to 15% by mass, and particularly preferably 1 to 10% by mass, with respect to the mass of the materials of the shield via Va.

### (2-6) <Other Components>

The materials of the shield via Va including the epsilon-type iron oxide may further contain various additives other than the components described above without interfering with the object of the present invention. Examples of the additives that can be contained in the materials of the shield via Va include a coloring agent, an antioxidant, an ultraviolet absorber, a fire retardant, a fire-retardant aid, a plasticizer, and a surfactant. Such additives are used in consideration of conventionally used amounts, without interfering with the object of the present invention.

### (2-7) <Paste Used for Forming Shield Via>

It is preferable that the shield via Va should be formed by, for example, pouring a paste containing the epsilon-type iron oxide into a through hole, and curing the paste. The through hole is formed in the circuit substrate 2 using a cutting tool, laser, or other such means.

The paste may contain, for example, the epsilon-type iron oxide, the substances added for adjusting relative permittivity and relative magnetic permeability, the polymer, and the other components described above. That is, the paste may contain a mixture of a dielectric material and a magnetically permeable material. In a case where the polymer is a curable resin, the paste contains a compound that is a precursor of the curable resin. In this case, the paste contains a curing agent, a curing promoter, a polymerization initiator, and the like, as necessary.

In the case of forming the shield via Va containing the epsilon-type iron oxide described above, composition of the paste is determined such that the relative permittivity is within the predetermined range described above. In general, the paste contains a dispersion medium. However, in a case where the paste contains a liquid precursor of a curable resin such as a liquid epoxy compound, the dispersion medium is not required.

As the dispersion medium, water, an organic solvent, and an aqueous solution of an organic solvent can be used. Among them, the organic solvent is preferable because it can tend to dissolve organic components and has a low latent heat of vaporization which facilitates removal by drying.

Preferred examples of the organic solvent used as the dispersion medium include: ketones such as diethyl ketone, methylbutyl ketone, dipropylketone, and cyclohexanone; alcohols such as n-pentanol, 4-methyl-2-pentanol, cyclohexanol, and diacetone alcohol; ether-based alcohols such as ethylene glycol monomethyl ether, ethylene glycol monoethyl ether, ethylene glycol monobutyl ether, propylene glycol monomethyl ether, propylene glycol monoethyl ether, diethylene glycol monomethyl ether, diethylene glycol monoethyl ether, diethylene glycol dimethyl ether, and diethylene glycol diethyl ether; saturated aliphatic monocarboxylate alkyl esters such as n-butyl acetate, and amyl acetate; lactate esters such as ethyl lactate, and n-butyl lactate; and ether-based esters such as methylcellosolve acetate, ethylcellosolve acetate, propylene glycol monomethyl ether acetate, propylene glycol monoethyl ether acetate, ethyl-3-ethoxypropionate, 2-methoxybutyl acetate, 3-methoxybutyl acetate, 4-methoxybutyl acetate, 2-methyl-3-methoxybutyl acetate, 3-methyl-3-methoxybutyl acetate, 3-ethyl-3-methoxybutyl acetate, 2-ethoxybutyl acetate, 4-ethoxybutyl acetate, 4-propoxybutyl acetate, and 2-methoxypentyl acetate. Among these organic solvents, a single solvent or a mixture of two or more solvents can be employed.

Solid content concentration of the paste is appropriately adjusted in accordance with a method of filling the through hole of the circuit substrate 2 with the paste, or the like. Typically, the solid content concentration of the paste is preferably 3 to 60% by mass, and more preferably 10 to 50% by mass. The solid content concentration of the paste is obtained by calculating, as a solid content mass, a sum of the mass of components that are not dissolved in the dispersion medium and the mass of components that are dissolved in the dispersion medium.

### (3) <Layout of Shield Vias>

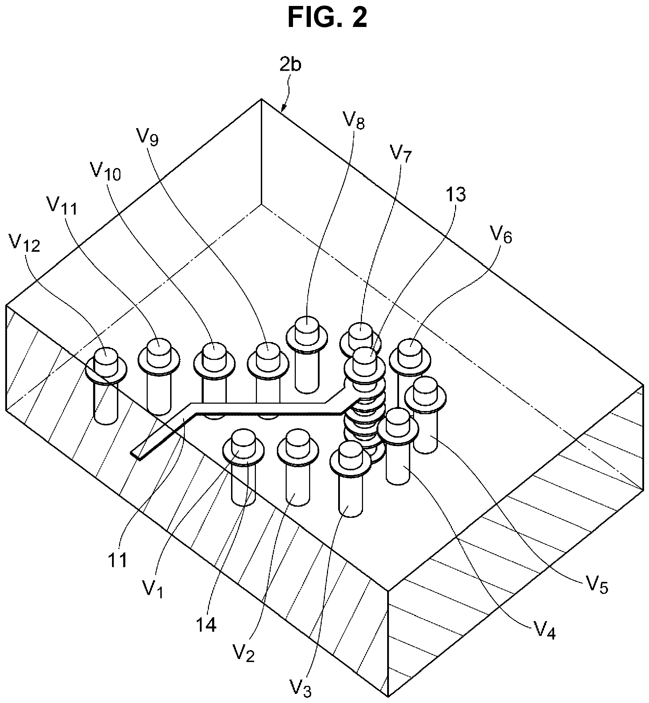

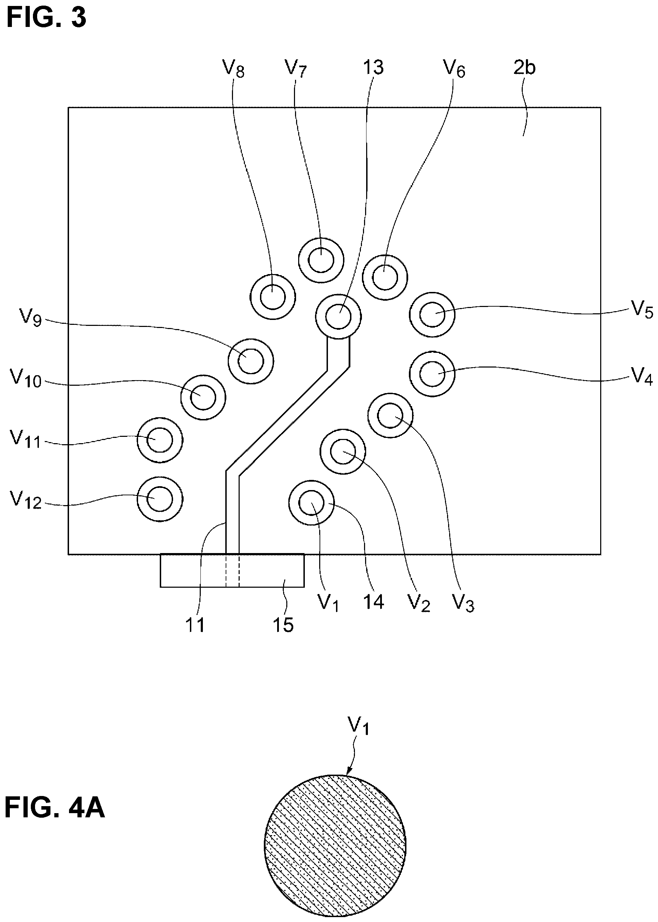

Fig. 2 and Fig. 3 are directed to another embodiment that is different from the embodiment shown in Fig. 1 described above, and hereinafter, a layout of the shield vias will be described with reference to Fig. 2 and Fig. 3. In an example shown in Fig. 2 and Fig. 3, a power feeder 11 for transmission that is laid in the multi-layer substrate 2b and a signal via 13 are provided instead of the power feeder 7b for transmission shown in Fig. 1.

Fig. 2 is a schematic view focusing on the power feeder 11 for transmission that is provided in the multi-layer substrate 2b and twelve shield vias V₁ to V₁₂ that surround the power feeder 11 for transmission. The other configurations are not illustrated in Fig. 2. Fig. 3 is a schematic top view of the multi-layer substrate 2b shown in Fig. 2, illustrating a layout of the power feeder 11 for transmission and the shield vias V₁ to V₁₂.

In this case, the power feeder 11 for transmission is provided inside the multi-layer substrate 2b, and is laid along a predetermined path from the edge portion of the multi-layer substrate 2b to the vicinity of the center of the multi-layer substrate 2b, located at a predetermined height.

At one end of the power feeder 11 for transmission on the edge portion of the multi-layer substrate 2b, a radio frequency integrated circuit 15 is provided. For example, an antenna connected to a passive filter is preferably employed as the radio frequency integrated circuit 15. In addition, at the other end of the power feeder 11 for transmission in the vicinity of the center of the multi-layer substrate 2b, the signal via 13 is provided that penetrates through the multi-layer substrate 2b in the thickness direction of the multi-layer substrate 2b. In a preferred configuration, the radio frequency integrated circuit 3 is connected to an end of the signal via 13 on a lower surface side of the multi-layer substrate 2b in Fig. 3.

In addition to such a configuration, the shield vias V₁ to V₁₂ are disposed in the multi-layer substrate 2b along both sides of the path of the power feeder 11 for transmission that is laid in the multi-layer substrate 2b to sandwich the power feeder 11 for transmission. In Fig. 2 and Fig. 3, reference numeral 14 represents a land that is provided on each of the shield vias V₁ to V₁₂.

Specifically, the six shield vias V₁ to V₆ are disposed on one side of the power feeder 11 for transmission along the path of the power feeder 11 for transmission, and separated from the power feeder 11 for transmission by a predetermined distance. The remaining six shield vias V₇ to V₁₂ are disposed on the other side of the power feeder 11 for transmission along the path of the power feeder 11 for transmission to face the shield vias V₁ to V₆, and separated from the power feeder 11 for transmission by a predetermined distance.

In such a multi-layer substrate 2b with the above-described configuration, when an alternating-current voltage is applied to the end of the signal via 13 on the lower surface side of the multi-layer substrate 2b in Fig. 3, an unnecessary electromagnetic wave is diffused inside the multi-layer substrate 2b from the end of the signal via 13 or the land of the signal via 13, and a bent portion of the power feeder 11 for transmission while the alternating-current voltage propagates to the radio frequency integrated circuit 15 through the power feeder 11 for transmission.

At this time, the shield vias V₁ to V₁₂ cause a natural resonance in a millimeter wave region of the unnecessary electromagnetic wave diffused in the multi-layer substrate 2b, and absorb the millimeter wave by the natural resonance. With the absorption of the millimeter wave by the shield vias V₁ to V₁₂, it is possible to reduce the unnecessary electromagnetic wave diffused in the multi-layer substrate 2b.

### (4) <Metal-Wall Shield Via>

### (4-1) <Configuration of Metal-Wall Shield Via>

In the embodiments described above, as shown in Fig. 4A, the pillar-shaped shield via V₁ made only of an electromagnetic wave absorption material having an electromagnetic wave absorption peak within a region of 30 to 300 GHz is employed as a millimeter wave absorber, but the present invention is not limited thereto.

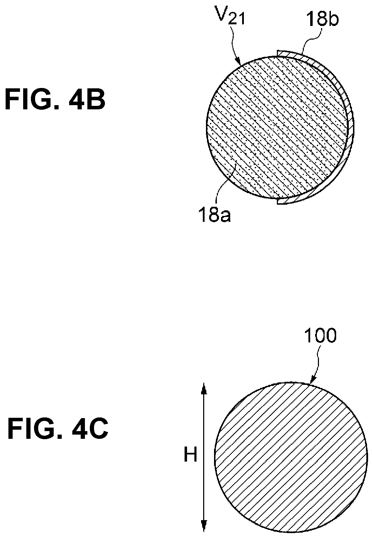

For example, as shown in Fig. 4B, a metal-wall shield via V₂₁ can be employed. The metal-wall shield via V₂₁ includes a pillar portion 18a that is columnar in shape and made of an electromagnetic wave absorption material having an electromagnetic wave absorption peak within a region of 30 to 300 GHz, and a metal wall 18b that is provided on an outer circumferential wall of the pillar portion 18a.

In this case, in the metal-wall shield via V₂₁, the metal wall 18b is provided on the outer circumferential wall of the pillar portion 18a to cover one-third or more and two-thirds or less of the circumference of the pillar portion 18a. When an unnecessary electromagnetic wave is incident on the pillar portion 18a as an incident wave, a natural resonance is generated by the pillar portion 18a in a millimeter wave region of the unnecessary electromagnetic wave, the unnecessary electromagnetic wave is absorbed by the natural resonance, and the incident wave that is not absorbed is reflected from the metal wall 18b toward the incident side.

Here, it is desirable that relative permittivity and relative magnetic permeability of the electromagnetic wave absorption material of the pillar portion 18a, and a via diameter of the pillar portion 18a should be adjusted such that the metal-wall shield via V₂₁ allows a reflected wave that is reflected from the surface of the pillar portion (an absorption portion) 18a (hereinafter, also referred to as a surface reflected wave) and a reflected wave of the incident wave reflected from the metal wall (a reflection portion) 18b (hereinafter, also referred to as a metal wall reflected wave) to interfere with and cancel out each other by impedance matching. With such a configuration of the metal-wall shield via V₂₁, it is possible to achieve a small-sized pillar portion 18a as well as to further reduce the unnecessary electromagnetic wave.

In order for the surface reflected wave and the metal wall reflected wave to interfere with and cancel out each other by impedance matching, the adjustment of the relative permittivity and the relative magnetic permeability of the pillar portion 18a can be performed in accordance with "(2-2) <Relative Permittivity Adjustment Method>" or "(2-3) <Relative Magnetic Permeability Adjustment Method>" described above. For example, the impedance matching occurs when relative permittivity of 1 to 150, relative magnetic permeability of 1 to 2, and the like satisfy a specific relationship in 79 GHz band.

### (4-2) <Layout of Metal Wall of Metal-Wall Shield Via>

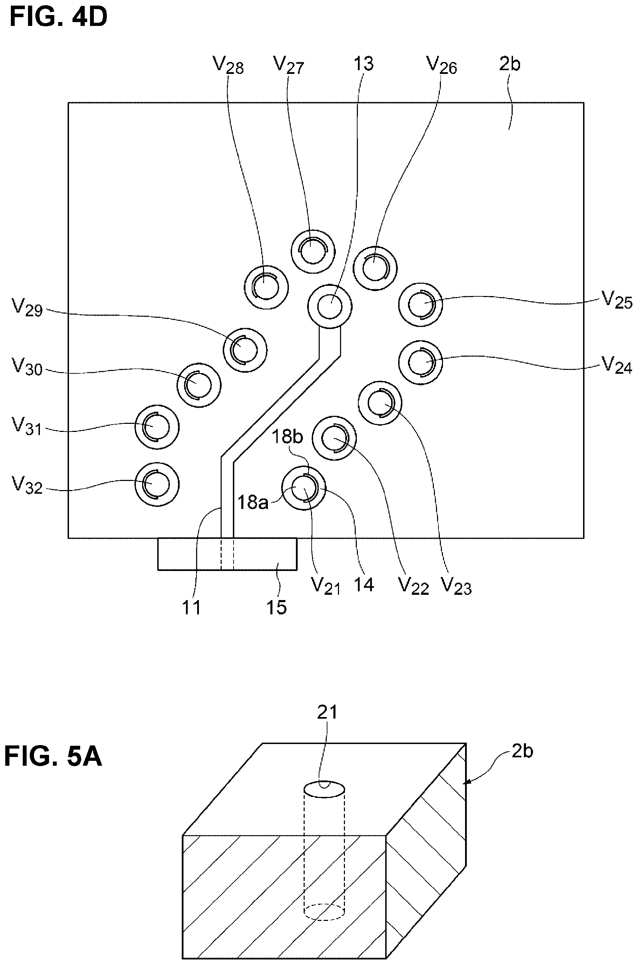

Next, with reference to Fig. 4D, an explanation will be given below on the position of the metal wall 18b of the above-described metal-wall shield via V₂₁ provided in the multi-layer substrate 2b shown in Fig. 3. Here, Fig. 4D is a schematic view illustrating a configuration when twelve metal-wall shield vias V₂₁ to V₃₂ are provided in an optimal state, in the multi-layer substrate 2b shown in Fig. 3.

As shown in Fig. 4D, the metal-wall shield vias V₂₁ to V₃₂ are disposed along the path of the power feeder 11 for transmission to surround the power feeder 11 for transmission, and separated from the power feeder 11 for transmission by a predetermined distance. In each of the metal-wall shield vias V₂₁ to V₃₂, a part of the outer circumferential wall of the pillar portion 18a on which the metal wall 18b is not provided is located on the power feeder 11 for transmission side, and an inner circumferential wall of the metal wall 18b faces the power feeder 11 for transmission across the pillar portion 18a.

With such a configuration, each of the metal-wall shield vias V₂₁ to V₃₂ allows an unnecessary electromagnetic wave, which starts to be diffused toward each of the metal-wall shield vias V₂₁ to V₃₂ from the power feeder 11 for transmission, to be incident on the pillar portion 18a as an incident wave and to be attenuated by the pillar portion 18a. Each of the metal-wall shield vias V₂₁ to V₃₂ causes a natural resonance by the pillar portion 18a in a millimeter wave region, and is able to effectively absorb the unnecessary electromagnetic wave in the millimeter wave region by the natural resonance.

The relative permittivity and the relative magnetic permeability of the electromagnetic wave absorption material of the pillar portion 18a, and the diameter of the pillar portion 18a are adjusted such that each of the metal-wall shield vias V₂₁ to V₃₂ allows the reflected wave reflected from the pillar portion 18a (the surface reflected wave) and the reflected wave of the incident wave which is not absorbed by the pillar portion 18a but is reflected from the metal wall 18b (the metal wall reflected wave) to interfere with and cancel out each other by impedance matching. It is therefore possible to absorb the initial unnecessary electromagnetic wave that starts to be diffused toward each of the metal-wall shield vias V₂₁ to V₃₂ from the power feeder 11 for transmission, thus promptly reducing noise in the circuit substrate 2.

In the metal-wall shield vias V₂₁ to V₃₂ of the embodiment described above, a part of the outer circumferential wall of the pillar portion 18a on which the metal wall 18b is not provided is located on the power feeder 11 for transmission side, and the inner circumferential wall of the metal wall 18b faces the power feeder 11 for transmission across the pillar portion 18a, but the present invention is not limited thereto. The metal wall 18b may be disposed at various angles with respect to the power feeder 11 for transmission.

### (4-3) <Method of Manufacturing Metal-Wall Shield Via>

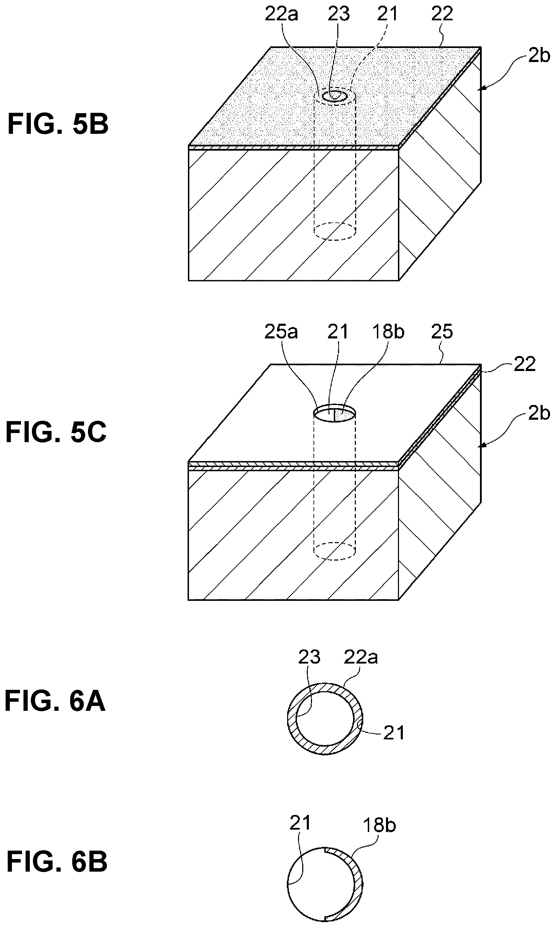

Next, a method of manufacturing the metal-wall shield via V₂₁ shown in Fig. 4B will be described below. In this method, as shown in Fig. 5A, a through hole 21 is formed in a thickness direction of the multi-layer substrate 2b using a cutting tool, laser, or other such means which is not illustrated, and then, as shown in Fig. 5B, a metal plating process is performed on the surface of the multi-layer substrate 2b. Accordingly, as shown in Fig. 6A, a metal plating layer 22a is formed on an inner circumferential wall of the through hole 21. At this time, as shown in Fig. 6A, the metal plating layer 22a may be formed into a film on the inner circumferential wall of the through hole 21 formed in the multi-layer substrate 2b to form a through hole 23. Alternatively, the through hole 21 formed in the multi-layer substrate 2b may be blocked with the metal plating layer 22a.

Next, part of the metal plating layer 22a in the through hole 21 is removed using a cutting tool, laser, or other such means which is not illustrated, and thus, as shown in Fig. 6B, the metal plating layer 22a remains as the metal wall 18b in an area of one-third or more and two-thirds or less of the circumference of the inner circumferential wall of the through hole 21 in the multi-layer substrate 2b.

Next, as shown in Fig. 5C, a silk screen plate 25 is disposed on the multi-layer substrate 2b. The silk screen plate 25 has an opening 25a corresponding to the through hole 21 of the multi-layer substrate 2b. Subsequently, for example, the paste containing epsilon-type iron oxide is poured into the through hole 21 of the multi-layer substrate 2b from the opening 25a, and then, the paste is cured.

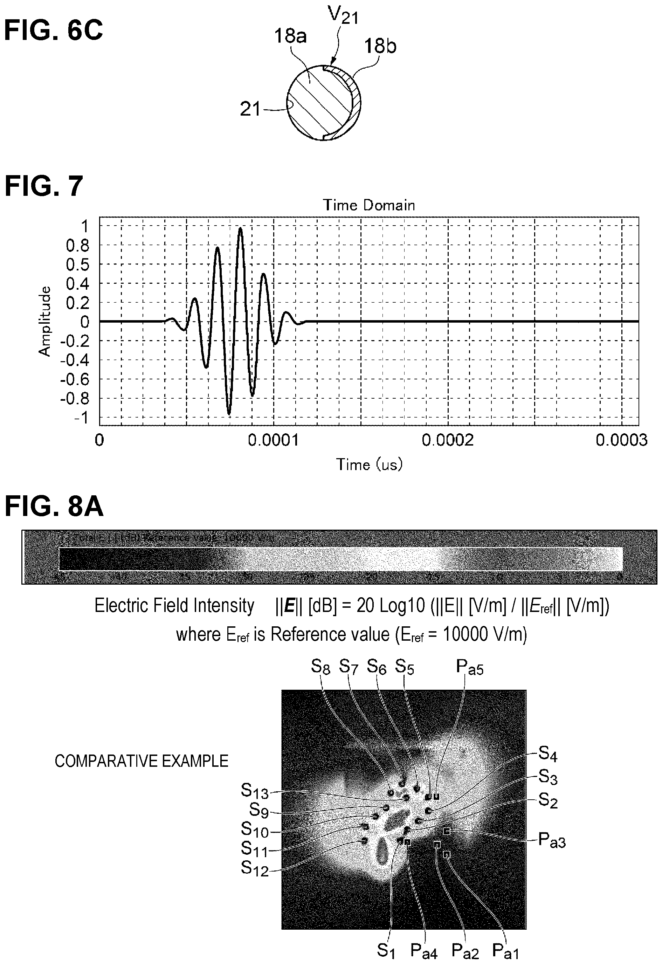

In this manner, as shown in Fig. 6C, it is possible to form, in the through hole 21 of the multi-layer substrate 2b, the metal-wall shield via V₂₁ having the metal wall 18b on a part of the outer circumferential wall of the pillar portion 18a made of the electromagnetic wave absorption material.

### (5) <Simulation Test>

Next, a simulation test by a finite-difference time-domain method (hereinafter referred to as an "FDTD method") and an electromagnetic field analysis are performed on each of the shield via V₁ of the present invention having a horizontal cross section shown in Fig. 4A, the metal-wall shield via V₂₁ of the present invention having a horizontal cross section shown in Fig. 4B, and a conventional metal shield via 100 having a horizontal cross section shown in Fig. 4C.

In this simulation test, suppose that the shield via V₁ shown in Fig. 4A is of a column shape and made of an electromagnetic wave absorption material containing 60% by mass of ε-GaₓFe₂₋ₓO₃ (x = 0.45), 5% by mass of a carbon nanotube, and 35% by mass of a cellulose-based resin, and has an electromagnetic wave absorption peak in 79 GHz band.

Moreover, suppose that the metal-wall shield via V₂₁ shown in Fig. 4B includes the pillar portion 18a made of the same electromagnetic wave absorption material as that of the shield via V₁ described above and the metal wall 18b made of a conductive metal material, such as gold, silver, copper, aluminum, or iron, on the outer circumferential wall of the pillar portion 18a to cover half a circumference of the pillar portion 18a. Further, suppose that the conventional metal shield via 100 shown in Fig. 4C is of a column shape and made of a conductive metal material such as gold, silver, copper, aluminum, or iron.

In the simulation test by the FDTD method, a simulated structure of the multi-layer substrate 2b shown in Fig. 2 and Fig. 3 is defined using an FDTD method analysis simulator (XFdtd) manufactured by Remcom Inc. Specifically, a cubic space of 3.500 mm × 3.000 mm × 1.344 mm is defined as a simulated multi-layer substrate 2b, and the power feeder 11 for transmission having the path as shown in Fig. 2 and Fig. 3 and the signal via 13 are defined in the cubic space.

Further, in Example 1, among the shield vias V₁ to V₁₂ shown in Fig. 2 and Fig. 3, simulated shield vias V₁ to V₅ are defined in five positions of the shield vias V₁ to V₅, respectively, and the conventional metal shield vias 100 are defined in the remaining seven positions of the shield vias V₆ to V₁₂, respectively. Then, as described above, the simulation test by the FDTD method is performed on a simulated structure in which the shield vias V₁ to V₅ and the metal shield vias 100 are defined.

In Example 2, among the shield vias V₁ to V₁₂ shown in Fig. 2 and Fig. 3, simulated metal-wall shield vias V₂₁ to V₂₅ (Fig. 4D) are defined in five positions of the shield vias V₁ to V₅, respectively, and the conventional metal shield vias 100 are defined in the remaining seven positions of the shield vias V₆ to V₁₂, respectively. Then, the simulation test by the FDTD method is performed on a simulated structure in which the metal-wall shield vias V₂₁ to V₂₅ and the metal shield vias 100 are defined. The metal wall 18b of each of the metal-wall shield vias V₂₁ to V₂₅ is defined to face the power feeder 11 for transmission through the pillar portion 18a, as with Fig. 4D.

In a comparative example, the conventional metal shield vias 100 are defined in the positions of the shield vias V₁ to V₁₂ shown in Fig. 2 and Fig. 3. Then, the simulation test by the FDTD method is performed on a simulated structure in which the metal shield vias 100 are defined.

In the simulation test by the FDTD method, each of the simulated shield vias V₁ to V₅, the simulated metal-wall shield vias V₂₁ to V₂₅, and the simulated metal shield vias 100 is defined to have a columnar structure having a via diameter H of 175 µm and a height of 644 µm. The metal shield via 100 is a perfect conductor, the shield vias V₁ to V₅ have relative permittivity of 21.7 and relative magnetic permeability of 1.20, and the metal-wall shield vias V₂₁ to V₂₅ have relative permittivity of 21.7 and relative magnetic permeability of 1.20.

In Example 1, Example 2, and the comparative example, electric field intensity distributions at 79 GHz in the multi-layer substrate 2b are measured, which are acquired 0.623 ns after a pulsed wave having a peak in about 79 GHz band with a waveform shown in Fig. 7 is incident on the power feeder 11 for transmission, and electromagnetic waves in a millimeter wave region are radiated in the multi-layer substrate 2b from the power feeder 11 for transmission.

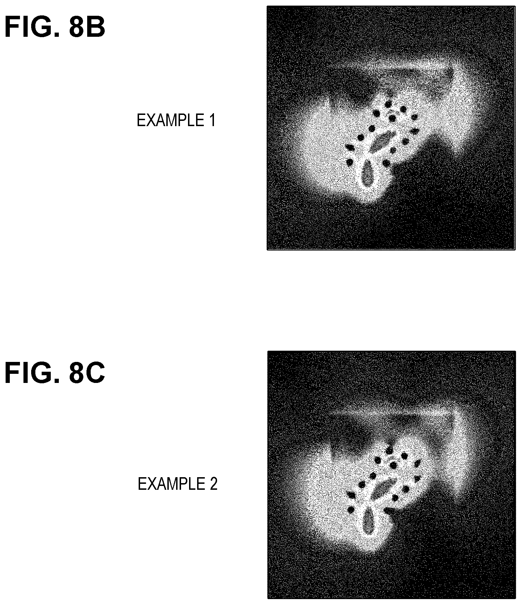

As a result, the electric field intensity distribution of the comparative example is obtained as shown in Fig. 8A, the electric field intensity distribution of Example 1 is obtained as shown in Fig. 8B, and the electric field intensity distribution of Example 2 is obtained as shown in Fig. 8C. Here, filled circles S₁ to S₁₂ in Fig. 8A correspond to the positions of the shield vias V₁ to V₁₂, respectively, shown in Fig. 2 and Fig. 3, and the filled circles S₁ to S₁₂ indicate the metal shield vias 100 in the comparative example. In addition, a filled circle S₁₃ indicates the position of the signal via 13. Filled circles in Fig. 8B and Fig. 8C also indicate the positions of vias, as with Fig. 8A.

The electric field intensities in the comparative example, Example 1, and Example 2 are evaluated by coloration of Fig. 8A, Fig. 8B, and Fig. 8C obtained as an analysis result. Note that Fig. 8A, Fig. 8B, and Fig. 8C are actually color images, assigning red, orange, yellow, green, and blue, in descending order of electric field intensity, which indicates that a warm color represents a relatively high intensity of electromagnetic waves.

In all of Fig. 8A, Fig. 8B, and Fig. 8C, the position of the power feeder 11 for transmission is indicated by a dark color, but this area is actually a warm color such as red or orange, indicating a relatively high intensity of electromagnetic waves. In Example 1 shown in Fig. 8B, the shield vias V₁ to V₅ made of the electromagnetic wave absorption material are provided at the positions of the filled circles S1 to S5 (refer to Fig. 8A), respectively. In a left side of Fig. 8B (where the shield vias V₁ to V₅ are provided), an area of low electric field intensity in Example 1 is found to be larger than that in the comparative example. Accordingly, in Example 1, the unnecessary electromagnetic waves to be diffused in the multi-layer substrate 2b can be more reduced than ever before.

In Example 2 shown in Fig. 8C, the metal-wall shield vias V₂₁ to V₂₅ are provided at the positions of the filled circles S1 to S5 (refer to Fig. 8A), respectively. In a left side of Fig. 8C (where the metal-wall shield vias V₂₁ to V₂₅ are provided), an area of low electric field intensity in Example 2 is found to be larger than that in Example 1 and the comparative example. Accordingly, in Example 2, the unnecessary electromagnetic waves to be diffused in the multi-layer substrate 2b can be further reduced.

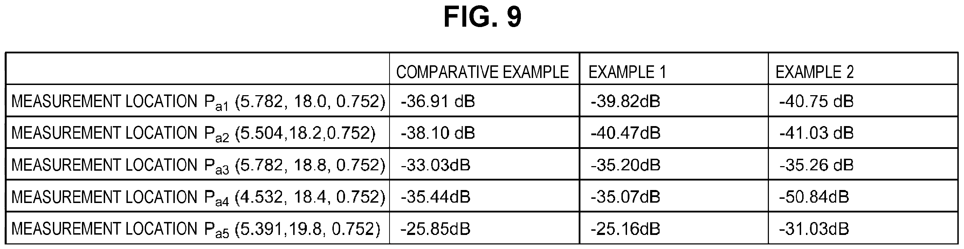

Next, for each analysis result of Fig. 8A, Fig. 8B, and Fig. 8C, the electric field intensities at five measurement (calculation) locations Pₐ₁, Pₐ₂, Pₐ₃, Pₐ₄, and Pₐ₅ shown in Fig. 8A are concretely calculated. The calculation results are shown in Fig. 9. In Fig. 9, for example, numerical values "5.782, 18.0, 0.752" at the measurement location Pₐ₁ indicate the position of Pₐ₁ (x coordinate, y coordinate, z coordinate) in Fig. 8A, Fig. 8B, and Fig. 8C.

Also from the results shown in Fig. 9, the electric field intensity in Example 1 and Example 2 is found to be lower than that in the comparative example, and the electric field intensity in Example 2 is found to be even lower than that in Example 1. Consequently, these results confirm that the shield vias V₁ to V₅ and the metal-wall shield vias V₂₁ to V₂₅ are able to absorb the unnecessary electromagnetic waves diffused in the multi-layer substrate 2b, leading to reduction in the unnecessary electromagnetic waves in the multi-layer substrate 2b, and further confirm that the metal-wall shield vias V₂₁ to V₂₅ are able to absorb much more unnecessary electromagnetic waves, leading to further reduction in the unnecessary electromagnetic waves.

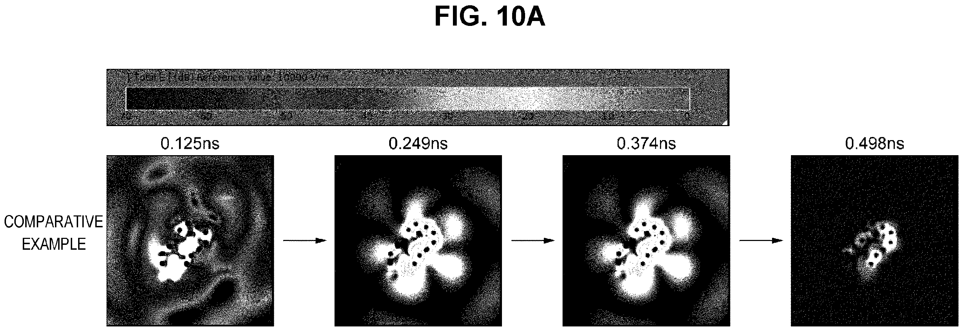

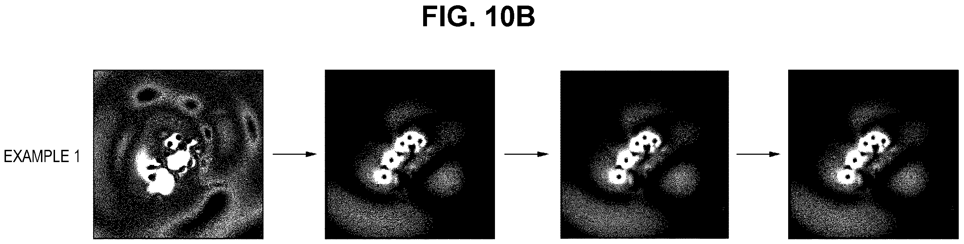

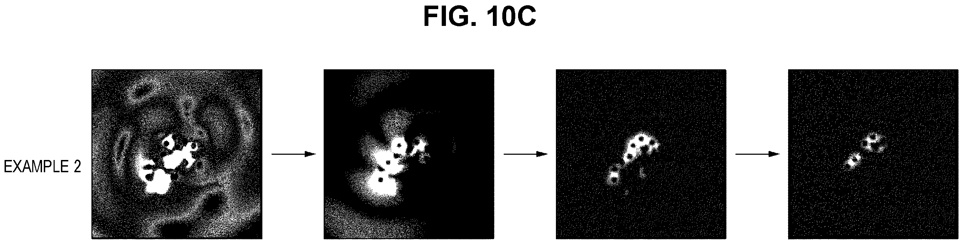

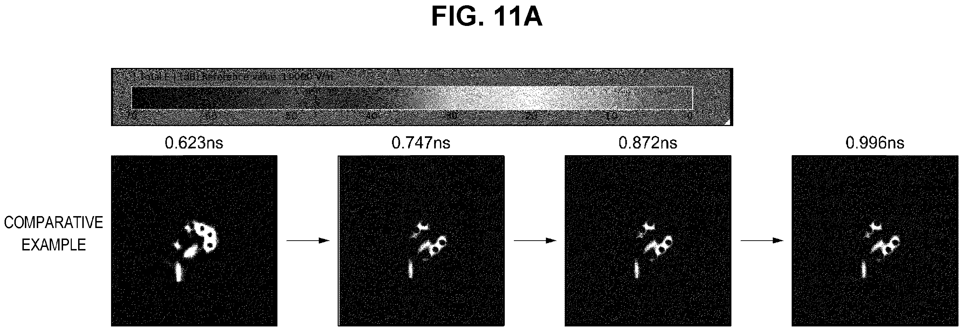

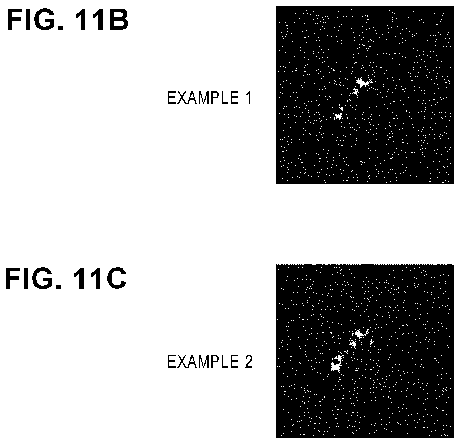

Next, time dependence of the electric field intensity during the simulation test by the FDTD method described above is measured for the comparative example, Example 1, and Example 2. The measurement results in the comparative example are shown in Fig. 10A and Fig. 11A, the measurement results in Example 1 are shown in Fig. 10B and Fig. 11B, and the measurement results in Example 2 are shown in Fig. 10C and Fig. 11C.

Fig. 10A, Fig. 10B, and Fig. 10C show electric field intensities acquired when 0.125 ns, 0.249 ns, 0.374 ns, and 0.498 ns have elapsed after the incidence of a pulsed wave, which has a peak in about 79 GHz band with the waveform shown in Fig. 7, on the power feeder 11 for transmission.

Fig. 11A shows electric field intensities acquired when 0.623 ns, 0.747 ns, 0.872 ns, and 0.996 ns have elapsed after the incidence of the pulsed wave on the power feeder 11 for transmission in the comparative example. Fig. 11B shows an electric field intensity acquired when 0.623 ns have elapsed after the incidence of the pulsed wave on the power feeder 11 for transmission in Example 1, and Fig. 11C shows an electric field intensity acquired when 0.623 ns have elapsed after the incidence of the pulsed wave on the power feeder 11 for transmission in Example 2.

As for the comparative example, Fig. 10A and Fig. 11A suggest that the electromagnetic waves remain in the multi-layer substrate 2b until 0.996 ns have elapsed after the incidence of the pulsed wave on the power feeder 11 for transmission, and it takes 0.996 ns to reduce the electromagnetic waves in the multi-layer substrate 2b. As for Example 1, on the other hand, Fig. 10B and Fig. 11B suggest that a period during which the electromagnetic waves remain in the multi-layer substrate 2b is shorter than that in the comparative example, and the electromagnetic waves in the multi-layer substrate 2b can be reduced in 0.623 ns.

As for Example 2, Fig. 10C and Fig. 11C also suggest that a period during which the electromagnetic waves remain in the multi-layer substrate 2b is shorter than that in the comparative example, and the electromagnetic waves in the multi-layer substrate 2b can be reduced in 0.623 ns. Further, the results in Example 2 confirm that an area where the electromagnetic waves are reduced is larger than that in Example 1, which leads to further reduction in the electromagnetic waves.

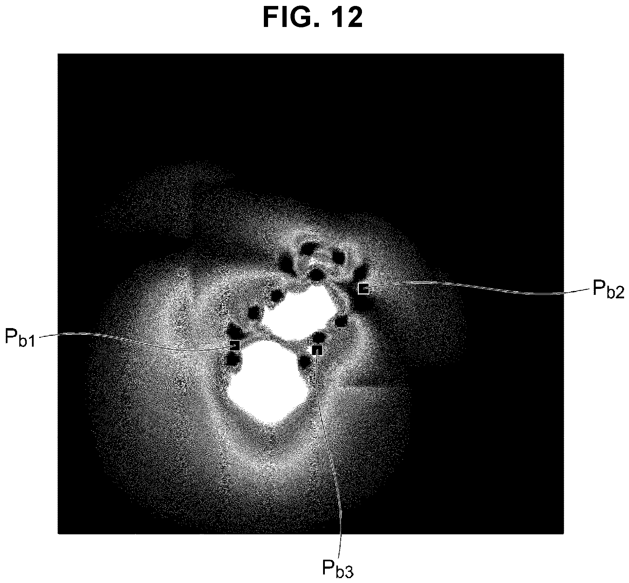

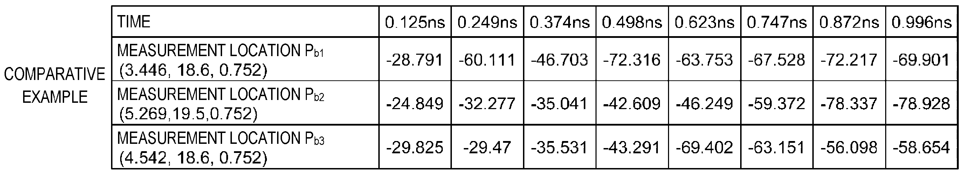

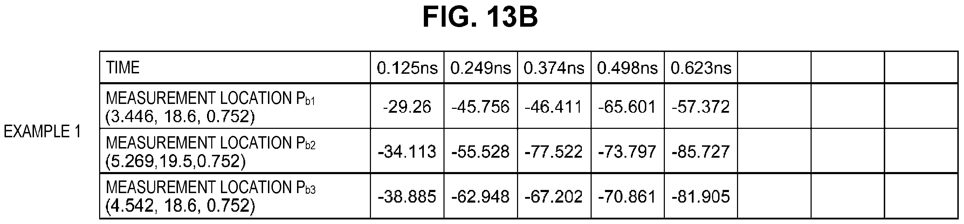

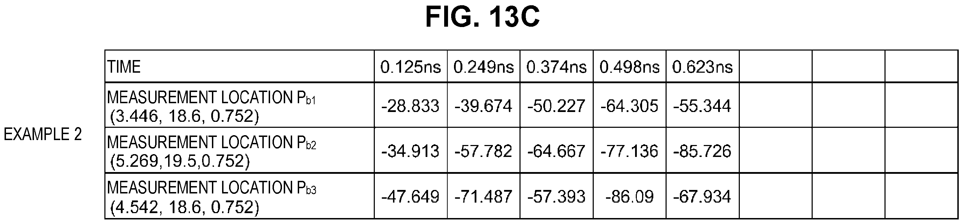

Next, electric field intensities at three measurement (calculation) locations P_{b1}, P_{b2}, and P_{b3} shown in Fig. 12 are concretely calculated for the analysis results of the comparative example shown in Fig. 10A and Fig. 11A, the analysis results of Example 1 shown in Fig. 10B and Fig. 11B, and the analysis results of Example 2 shown in Fig. 10C and Fig. 11C. The calculation results are shown in Fig. 13.

From the results shown in Fig. 13, the time required to reach a relatively low electric field intensity in Example 1 and Example 2 is found to be shorter than that in the comparative example, which indicates that the electromagnetic waves can be reduced in a short period of time. Further, the electric field intensities in Example 2 are found to be decreased in an even shorter period of time compared to Example 1. These findings confirm that the shield vias V₁ to V₅ and the metal-wall shield vias V₂₁ to V₂₅ are able to absorb the unnecessary electromagnetic waves diffused in the multi-layer substrate 2b, thereby reducing the unnecessary electromagnetic waves in the multi-layer substrate 2b in a shorter period of time compared to the comparative example.

### (6) Functions and Effects

In the circuit substrate 2 having the above-described configuration according to the present invention, the shield vias V₁ to V₁₂ having the electromagnetic wave absorption peak in a region of 30 to 300 GHz are provided inside the multi-layer substrate 2b in which the plurality of dielectric layers 2e are stacked. With this structure of the circuit substrate 2, the unnecessary electromagnetic waves generated inside the circuit substrate 2 can not only be reduced by being simply reflected from the shield vias V₁ to V₁₂, but also absorbed by the shield vias V₁ to V₁₂, which results in a much more reduction in noise than before in the circuit substrate 2.

In the embodiments, by providing the shield vias V₁ to V₁₂ inside the multi-layer substrate 2b as described above, it is possible for the shield vias V₁ to V₁₂ to absorb the unnecessary electromagnetic waves diffused inside the multi-layer substrate 2b, thereby achieving a method of reducing noise in the circuit substrate 2.

In addition, by providing, as the millimeter wave absorber in the circuit substrate 2, the metal-wall shield vias V₂₁ to V₂₅, each of which includes the pillar portion 18a having the electromagnetic wave absorption peak in a region of 30 to 300 GHz and the metal wall 18b on the outer circumferential wall of the pillar portion 18a to cover one-third or more and two-thirds or less of the circumference of the pillar portion 18a, it is possible for the reflected wave of the electromagnetic wave reflected from the pillar portion 18a and the reflected wave of the incident wave reflected from the metal wall 18b to interfere with and cancel out each other by impedance matching, for example. Accordingly, it is possible to reduce much more noise than before in the circuit substrate 2 as well as to achieve small-sized metal-wall shield vias V₂₁ to V₂₅.

In a conventional substrate forming process, it is difficult to arrange the metal shield vias highly densely to shield a high frequency wave signal, and thus, a transmission signal may be slightly leaked into inner layers of the substrate from between the metal shield vias. In general, a transmission signal is a high frequency wave signal with a relatively high intensity, and a received signal is a high frequency wave signal with a relatively low intensity. For this reason, even if a small portion of the transmission signal is leaked, communication quality of entire communication device is greatly impaired once the transmission signal is mixed into the received signal.

In order to arrange the metal shield vias highly densely in the circuit substrate, a specific process, such as low temperature co-fired ceramics technology or micromachining technology, might be employed. However, such a process may raise a manufacturing cost and cause a significant increase in price of the communication device itself.

In contrast, in the circuit substrate 2, the shield vias V₁ to V₁₂ absorb the unnecessary electromagnetic waves to reduce noise in the circuit substrate 2, and thus, even if the shield vias V₁ to V₁₂ are not highly densely arranged using the conventional substrate forming process, noise in the circuit substrate 2 can be reduced. Accordingly, the unnecessary electromagnetic waves generated in the circuit substrate 2 can be further suppressed, and noise in the circuit substrate 2 can be reduced without greatly changing the conventional substrate forming process.

In the embodiments, noise in the circuit substrate 2 can be reduced using the conventional substrate forming process at a low cost without using a specific process at a high cost for arranging the shield vias V₁ to V₁₂ highly densely, and thus, it is possible to prevent an increase in the manufacturing cost due to a change in the manufacturing process, and provide communication devices and communication systems having high communication quality at a low price.

### (7) Another Embodiment

The present invention is not limited to the above embodiments, and many modifications and variations will be apparent to those of ordinary skill in the art without departing from the scope of the present invention. For example, in the embodiments described above, the column-shaped shield via and metal-wall shield via are employed as the millimeter wave absorber and the built-in millimeter wave absorber for a circuit substrate, but the present invention is not limited thereto, and the shield vias and the metal-wall shield vias of various pillar shapes may be employed, such as an elliptical column, a quadrangular prism, and a polygonal prism.

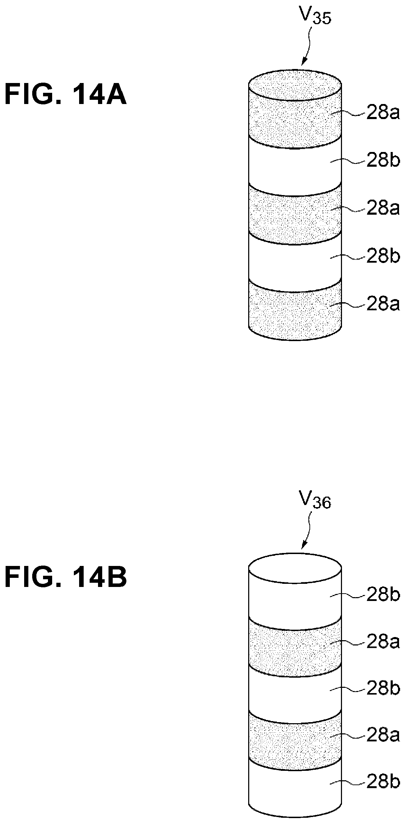

As shown in Fig. 14A and Fig. 14B, shield vias V₃₅ and V₃₆ can be employed as another millimeter wave absorber and built-in millimeter wave absorber for a circuit substrate. Each of the shield vias V₃₅ and V₃₆ includes first pillar portions 28a of a pillar shape, made of an electromagnetic wave absorption material having an electromagnetic wave absorption peak within a region of 30 to 300 GHz, and second pillar portions 28b of a pillar shape, made of a metal material. The first pillar portions 28a and the second pillar portions 28b are alternately stacked to provide pillar-shaped shield vias V₃₅ and V₃₆. Preferred examples of the metal material of the second pillar portions 28b include aluminum, titanium, SUS, copper, brass, silver, gold, and platinum, from the viewpoint of reflective properties of electromagnetic waves.

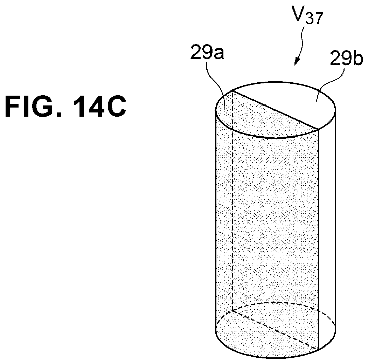

Further, as shown in Fig. 14C, a shield via V₃₇ can be employed as still another millimeter wave absorber and built-in millimeter wave absorber for a circuit substrate. The shield via V₃₇ includes a first half body portion 29a of a semicircular column shape, having an electromagnetic wave absorption peak within a region of 30 to 300 GHz, and a second half body portion 29b of a semicircular column shape, made of a metal material. The first half body portion 29a and the second half body portion 29b are joined to provide a column-shaped shield via V₃₇. Instead of the semicircular column shape, the first half body portion 29a and the second half body portion 29b may have various half pillar shapes with semi-elliptical cross section, triangular cross section, or quadrangular cross section, among others. Therefore, the first half body portion 29a and the second half body portion 29b are joined to provide shield vias of various pillar shapes. Preferred examples of the metal material of the second half body portion 29b include aluminum, titanium, SUS, copper, brass, silver, gold, and platinum, from the viewpoint of the reflective properties of the electromagnetic waves. As with the metal-wall shield via V₂₁, for example, the shield via V₃₇ allows a reflected wave of an electromagnetic wave that is reflected from the first half body portion (an absorption portion) 29a and a reflected wave of an incident wave that is reflected from the second half body portion (a reflection portion) 29b to interfere with and cancel out each other by impedance matching.

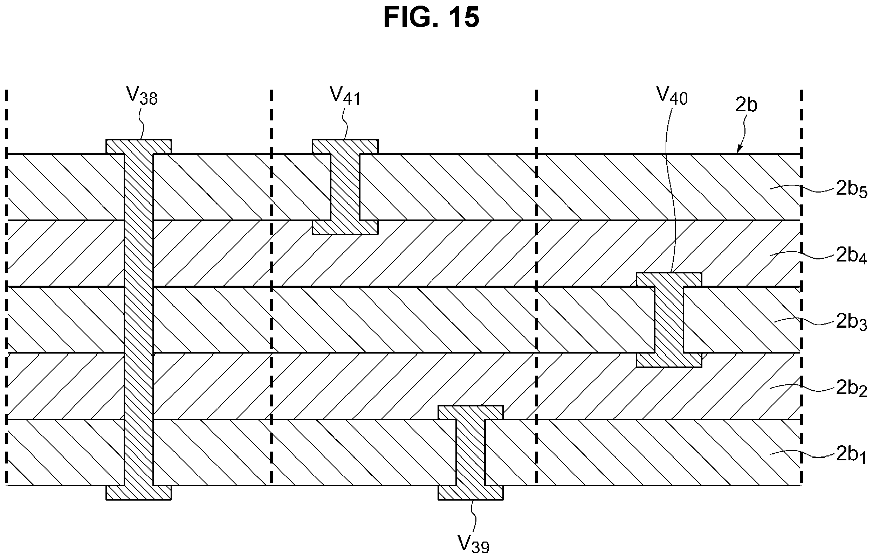

In the embodiments described above, for example, as shown in Fig. 15, a shield via V₃₈ penetrating through all dielectric layers 2b₁ to 2b₅ constituting the multi-layer substrate 2b is employed as the millimeter wave absorber and the built-in millimeter wave absorber for a circuit substrate, but the present invention is not limited thereto. Instead, for example, shield vias V₃₉ and V₄₁ may be employed that penetrate through only the dielectric layers 2b₁ and 2b₅, respectively, located on both surface sides of the multi-layer substrate 2b and penetrate through both the surfaces and inner layers of the multi-layer substrate 2b.

Further, as shown in Fig. 15, another millimeter wave absorber and another built-in millimeter wave absorber for a circuit substrate may be a shield via V₄₀ that penetrates through only the dielectric layer 2b₃ which is an inner layer of the multi-layer substrate 2b, and the shield via V₄₀ is not exposed on the surfaces of the multi-layer substrate 2b. Even with such a configuration, the unnecessary electromagnetic waves generated inside the circuit substrate 2 can be absorbed by the shield vias V₃₉, V₄₀, and V₄₁, which leads to a much more reduction in noise than before in the circuit substrate 2. The shield vias V₃₉, V₄₀, and V₄₁ described above may be designed as metal-wall shield vias.

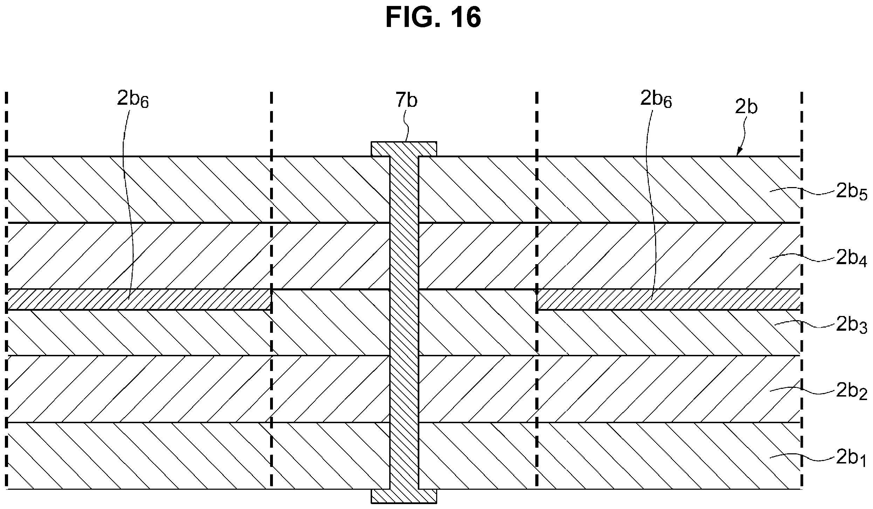

In the embodiments described above, the pillar-shaped shield via and metal-wall shield via are employed as the millimeter wave absorber and the built-in millimeter wave absorber for a circuit substrate, but the present invention is not limited thereto. Instead, as shown in Fig. 16, shield layers 2b₆ of a layer shape may be provided along an in-plane direction of the multi-layer substrate 2b and made of an electromagnetic wave absorption material having an electromagnetic wave absorption peak within a region of 30 to 300 GHz. Even with such a configuration, for example, the unnecessary electromagnetic waves generated inside the circuit substrate 2 can be absorbed by the shield layers 2b₆, which results in a much more reduction in noise than before in the circuit substrate 2.

In Fig. 16, the shield layers 2b₆ are located on both sides of the power feeder 7b for transmission to surround the power feeder 7b for transmission, and the unnecessary electromagnetic waves diffused from the power feeder 7b for transmission are absorbed by the shield layers 2b₆ on both sides. In this case, the shield layer 2b₆ shown in Fig. 16 is one layer, but, for example, a plurality of shield layers 2b₆ may be stacked at a predetermined interval. In addition, such a shield layer 2b₆ may be provided together with the shield via V of the present invention made of the electromagnetic wave absorption material described above, or the shield layer 2b₆ may be provided together with the metal-wall shield via.

In the embodiments described above, the shield vias or the metal-wall shield vias are provided around the power feeder 7b for transmission as a power feeder, but the present invention is not limited thereto. Instead, the shield vias or the metal-wall shield vias may be provided around the power feeder for reception that is connected to the receiving antenna.

One or more of the conventional metal shield vias that are provided inside the circuit substrate may be replaced by the shield via, the metal-wall shield via, or the shield layer of the embodiments. Even with such a configuration, the electromagnetic waves in the circuit substrate 2 can be more reduced than ever before.

### (8) <Metal-wall unit in Another Embodiment>

### (8-1) <Configuration of Metal-wall unit>

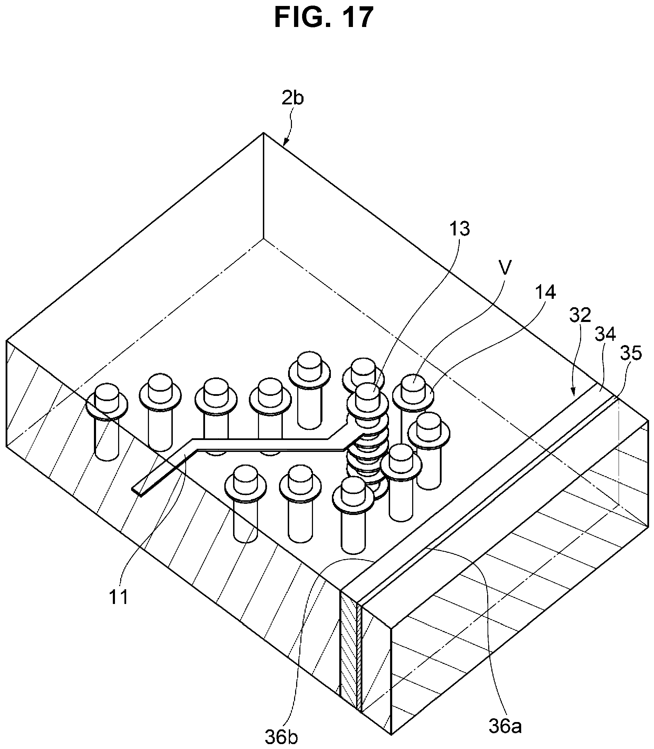

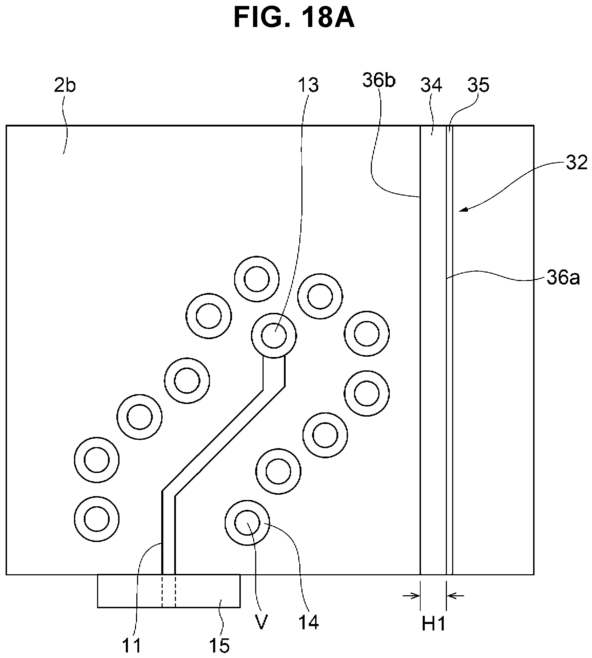

In the embodiments described above, the pillar-shaped shield vias V₁ to V₁₂, the metal-wall shield via V₂₁, the shield layer 2b₆ of a layer shape located along the in-plane direction of the multi-layer substrate 2b, and the like are provided as the millimeter wave absorber and the built-in millimeter wave absorber in the multi-layer substrate 2b, but the present invention is not limited thereto. For example, as shown in Fig. 17 in which the same reference numerals are used to designate the same portions as those in Fig. 2 and as shown in Fig. 18A in which the same reference numerals are used to designate the same portions as those of Fig. 3, a metal-wall unit 32 having a wall shape may be provided as the millimeter wave absorber and the built-in millimeter wave absorber in the multi-layer substrate 2b.

As shown in Fig. 17 and Fig. 18A, the metal-wall unit 32 includes a wall portion 34 having a wall shape and made of the same electromagnetic wave absorption material as that in the embodiments described above, and a metal wall (a reflection portion) 35 having a wall shape provided on a first lateral face 36a extending along a longitudinal direction of the wall portion 34. The wall portion 34 and the metal wall 35 penetrate through the multi-layer substrate 2b in the thickness direction of the multi-layer substrate 2b. As for the wall portion 34, the metal wall 35 is not provided on a second lateral face 36b on the side opposite to the first lateral face 36a on which the metal wall 35 is provided, and thus, the second lateral face 36b of the wall portion 34 is exposed in the multi-layer substrate 2b.

In the multi-layer substrate 2b, the conventional pillar-shaped metal vias V are disposed along the path of the power feeder 11 for transmission to surround the power feeder 11 for transmission, and the metal-wall unit 32 including the wall portion 34 made of the electromagnetic wave absorption material is provided, but the present invention is not limited thereto. For example, in addition to the metal-wall unit 32, the shield vias V₁ to V₁₂, the metal-wall shield via V₂₁, the shield layer 2b₆ of a layer shape, or the like, which are made of the electromagnetic wave absorption material described above, may be provided.

In this case, in the metal-wall unit 32, the second lateral face 36b of the wall portion 34 on which the metal wall 35 is not provided is located on the power feeder 11 for transmission side, and the metal wall 35 faces the power feeder 11 for transmission across the wall portion 34.

The metal-wall unit 32 allows unnecessary electromagnetic waves diffused from the power feeder 11 for transmission toward the metal-wall unit 32 to be incident on the wall portion 34 as an incident wave, which causes the unnecessary electromagnetic waves to attenuate in the wall portion 34. The metal-wall unit 32 also allows a natural resonance to occur in the wall portion 34 in a millimeter wave region, thereby effectively absorbing the unnecessary electromagnetic waves in the millimeter wave region by the natural resonance.

Relative permittivity and relative magnetic permeability of the electromagnetic wave absorption material of the wall portion 34, and a thickness H1 of the wall portion 34 are adjusted such that the metal-wall unit 32 allows a reflected wave reflected from the second lateral face 36b of the wall portion 34 (a surface reflected wave) and a reflected wave of an incident wave which is not absorbed by the wall portion 34 but is reflected from the metal wall 35 (a metal wall reflected wave) to interfere with and cancel out each other by impedance matching. As described above, the metal-wall unit 32 allows the surface reflected wave from the second lateral face 36b and the metal wall reflected wave to interfere with and cancel out each other by impedance matching, and thus, is able to absorb the unnecessary electromagnetic waves diffused from the power feeder 11 for transmission toward the metal-wall unit 32, which makes it possible to promptly reduce noise even further in the multi-layer substrate 2b.

In the embodiments described above, the metal-wall unit 32 is disposed such that the second lateral face 36b of the wall portion 34 on which the metal wall 35 is not provided is located on the power feeder 11 for transmission side, and the inner wall of the metal wall 35 faces the power feeder 11 for transmission across the wall portion 34, but the present invention is not limited thereto, and the metal-wall unit 32 may be disposed at various positions with respect to the power feeder 11 for transmission. In addition, the metal-wall unit 32 is vertically disposed inside the multi-layer substrate 2b, but the present invention is not limited thereto, and the metal-wall unit 32 may be tilted inside the multi-layer substrate 2b, extending in an oblique direction, at a predetermined angle with respect to the thickness direction of the multi-layer substrate 2b.

In the embodiments, the thickness H1 of the wall portion 34 of the metal-wall unit 32 is preferably several hundred µm (100 to 200 µm is particularly desirable in 79 GHz band), and it is desirable that the thickness H1 of the wall portion 34 should be selected in accordance with the millimeter wave region of the unnecessary electromagnetic waves, and the like.

Such a metal-wall unit 32 can also be produced in the multi-layer substrate 2b, in accordance with " (4-3) <Method of Manufacturing Metal-Wall Shield Via>" described above, for example.

### (8-2) <Simulation Test>

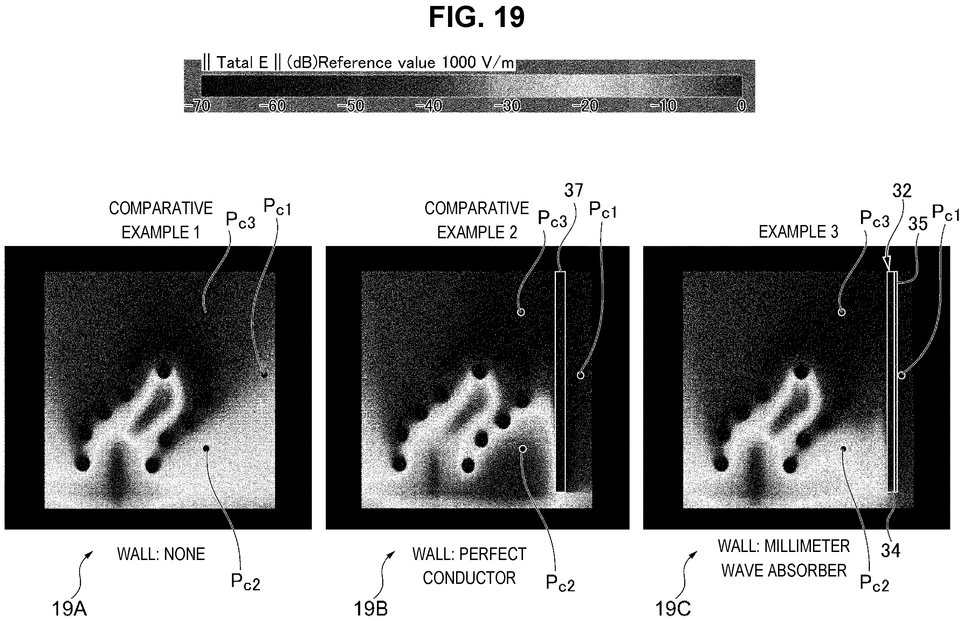

Here, Fig. 19 shows images of results of electromagnetic field analysis after performing the simulation test by the FDTD method with respect to Comparative Example 1, Comparative Example 2, and Example 3 which have different structures.

Comparative Example 1 is directed to a simulated structure in which the conventional metal vias V, the power feeder 11 for transmission, and the like are defined in the multi-layer substrate 2b similarly to the configuration shown in Fig. 17, but the metal-wall unit 32 is not provided. Comparative Example 2 is directed to another simulated structure in which the conventional metal vias V, the power feeder 11 for transmission, and the like are defined in the multi-layer substrate 2b similarly to the configuration shown in Fig. 17, but instead of the metal-wall unit 32 shown in Fig. 17, a metal wall 37 is defined at the same position as that of the metal-wall unit 32. Example 3 is directed to a simulated structure having the same configuration as that in Fig. 17 in which the conventional metal vias V, the power feeder 11 for transmission, and the like are defined in the multi-layer substrate 2b, and the metal-wall unit 32 is further defined in the multi-layer substrate 2b.

In the simulation test by the FDTD method, each via V is defined as a column-shaped structure having the via diameter H of 175 µm and the height of 644 µm. Each of the metal vias V and the metal walls 37 and 35 is a perfect conductor, and the wall portion 34 of the metal-wall unit 32 has relative permittivity of 21.7 and relative magnetic permeability of 1.20.

In Comparative Example 2, the thickness of the metal wall 37 is defined to be 175 µm. In Example 3, the thickness of the wall portion 34 is defined to be 175 µm, and the thickness of the metal wall 35 is defined to be 0 µm (that is, the metal wall 35 is defined as a metal surface without a thickness).

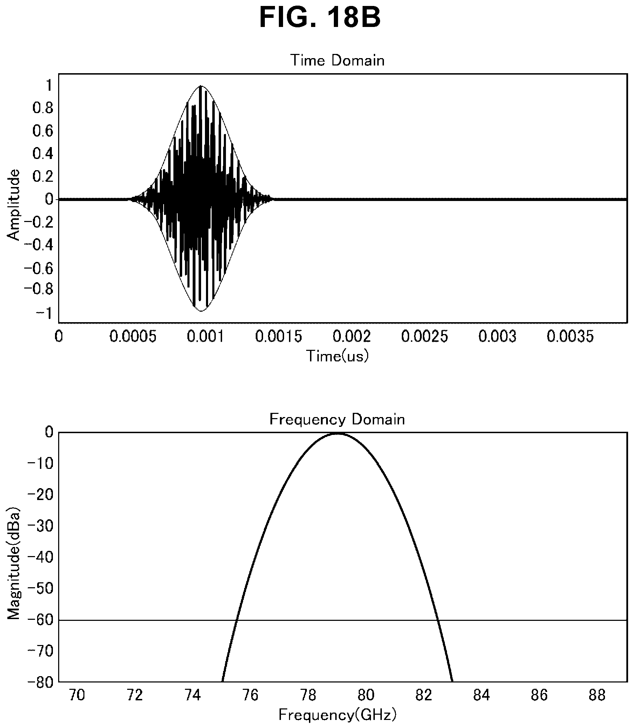

In Comparative Example 1, Comparative Example 2, and Example 3, electric field intensity distributions at 80 GHz in the multi-layer substrate 2b are measured, which is acquired until about 2 ns have elapsed after a pulsed wave having a peak in about 79 GHz band with a waveform shown in Fig. 18B is incident on the power feeder 11 for transmission, and electromagnetic waves in a millimeter wave region are radiated into the multi-layer substrate 2b from the power feeder 11 for transmission.

As a result, the electric field intensity distribution of Comparative Example 1 is obtained as shown in 19A of Fig. 19 (denoted as "WALL: NONE"), the electric field intensity distribution of Comparative Example 2 is obtained as shown in 19B of Fig. 19 (denoted as "WALL: PERFECT CONDUCTOR"), and the electric field intensity distribution of Example 3 is obtained as shown in 19C of Fig. 19 (denoted as "WALL: MILLIMETER WAVE ABSORBER").

The electric field intensities of Comparative Example 1, Comparative Example 2, and Example 3 are evaluated by coloration of each image of Fig. 19. Note that Fig. 19 actually shows color images, assigning red, orange, yellow, green, blue, and violet, in descending order of electric field intensity, which indicates that a warm color represents a relatively high intensity of electromagnetic waves.

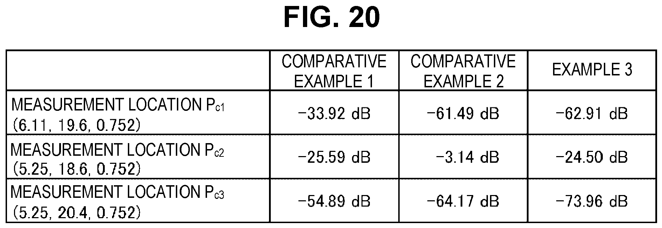

In Fig. 19, the position of the power feeder 11 for transmission is indicated by a dark color, but this area is actually a warm color such as red or orange, indicating a relatively high intensity of electromagnetic waves. For each of the analysis results shown in 19A, 19B, and 19C of Fig. 19, the electric field intensities at measurement (calculation) locations P_{c1}, P_{c2}, and P_{c3} are concretely calculated. The calculation results are shown in Fig. 20. In Fig. 20, for example, numerical values "6.11, 19.6, 0.752" at the measurement location P_{c1} indicates the position of P_{c1} (x coordinate, y coordinate, z coordinate) in Fig. 19.

In 19B and 19C of Fig. 19, the measurement location P_{c1} indicates a predetermined position in an area located on the opposite side of the metal wall 35 and the metal-wall unit 32 from the power feeder 11 for transmission. In 19B and 19C of Fig. 19, the measurement location P_{c2} indicates a predetermined position in an area between predetermined vias V surrounding the power feeder 11 for transmission and the metal wall 35 (the metal-wall unit 32). In 19B and 19C of Fig. 19, the measurement location P_{c3} indicates an upper position of the power feeder 11 for transmission and the vias V that is not shielded by the metal wall 35 and the metal-wall unit 32.

As shown in 19A of Fig. 19 and Fig. 20, in Comparative Example 1 in which only the vias V are provided, the electromagnetic waves are found to have a relatively high intensity in a region surrounded by the vias V, and spread to the right and left in a lower region of the power feeder 11 for transmission in which the vias V are not provided.

As shown in 19B of Fig. 19 and Fig. 20, in Comparative Example 2 in which the metal wall 37 is provided, the intensity of the electromagnetic waves is found to be relatively low at the measurement location P_{c1} located on the opposite side of the metal wall 37 from the power feeder 11 for transmission, which indicates that the electromagnetic waves are shielded by the metal wall 37. On the other hand, at the measurement location P_{c2} between the power feeder 11 for transmission and the metal wall 37, the intensity of the electromagnetic waves is found to be higher than that in Comparative Example 1. This suggests that in Comparative Example 2, the electromagnetic waves from the power feeder 11 for transmission are reflected from the metal wall 37, and the reflected electromagnetic waves are reflected again from the vias V, and thus, the electromagnetic waves are stuck between the power feeder 11 for transmission and the metal wall 37, which leads to a higher intensity of the electromagnetic waves at the measurement location P_{c2} than that in Comparative Example 1.

In contrast, in Example 3 in which the metal-wall unit 32 is provided, as shown in 19C of Fig. 19 and Fig. 20, the intensity of the electromagnetic waves is found to be relatively low not only at the measurement location P_{c1} located on the opposite side of the metal wall 37 from the power feeder 11 for transmission, but also at the measurement location P_{c2} between the power feeder 11 for transmission and the metal wall 37. This suggests that in Example 3, the unnecessary electromagnetic waves diffused in the multi-layer substrate 2b are absorbed by the metal-wall unit 32, which leads to reduction in the unnecessary electromagnetic waves in the multi-layer substrate 2b.

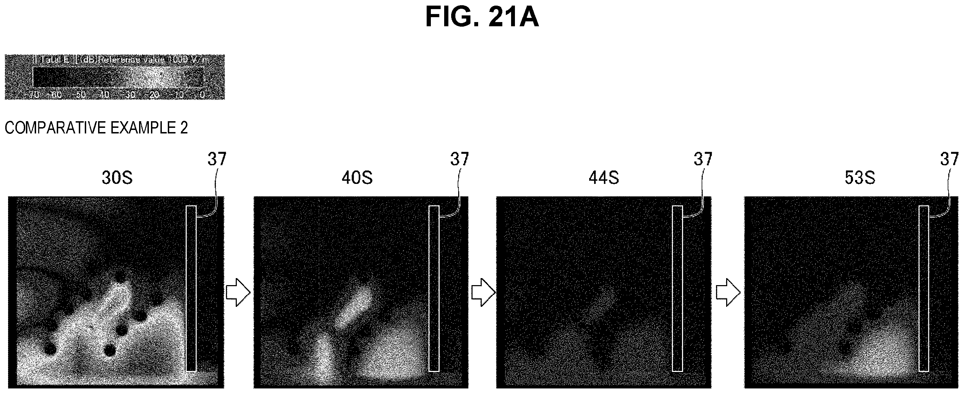

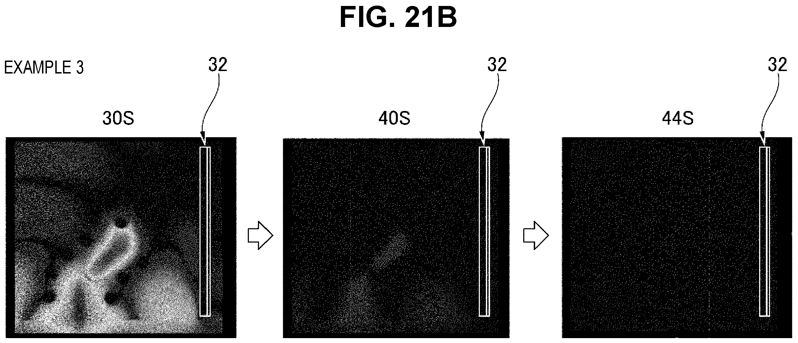

Next, the time dependence of the electric field intensity during the simulation test by the FDTD method described above is measured for Comparative Example 2 and Example 3. The measurement results in Comparative Example 2 are shown in Fig. 21A, and the measurement results in Example 3 are shown in Fig. 21B.

Fig. 21A shows electric field intensities in Comparative Example 2 acquired when 30 s, 40 s, 44 s, and 53 s have elapsed after the incidence of a pulsed wave, which has a peak in about 79 GHz band with the waveform shown in Fig. 18B, on the power feeder 11 for transmission. Fig. 21B shows electric field intensities in Example 3 acquired when 30 s, 40 s, and 44 s have elapsed after the incidence of the pulsed wave, which has a peak in about 79 GHz band with the waveform shown in Fig. 18B, on the power feeder 11 for transmission.

As for Comparative Example 2, Fig. 21A suggests that the electromagnetic waves still exist in the region between the power feeder 11 for transmission and the metal wall 37 in the multi-layer substrate 2b even 53 seconds after the incidence of the pulsed wave on the power feeder 11 for transmission. On the other hand, as for Example 3, Fig. 21B suggests that a period during which the electromagnetic waves remain in the multi-layer substrate 2b is shorter than that in Comparative Example 2, and by the time 44 seconds have passed, the electromagnetic waves no longer exist in the multi-layer substrate 2b.

As described above, from the results shown in Fig. 21B, the time required to reach a relatively low electric field intensity in Example 3 is found to be shorter than that in Comparative Example 2, which indicates that the electromagnetic waves can be reduced in a short period of time. These findings confirm that the metal-wall unit 32 is able to absorb the unnecessary electromagnetic waves diffused in the multi-layer substrate 2b, thereby reducing the unnecessary electromagnetic waves in the multi-layer substrate 2b in a short period of time, compared to Comparative Example 2 in which the metal wall 37 is simply provided.

### (9) <Embodiment in Which Two Metal-wall units Face Each Other>

### (9-1) <Configuration of Metal-wall units Facing Each Other>

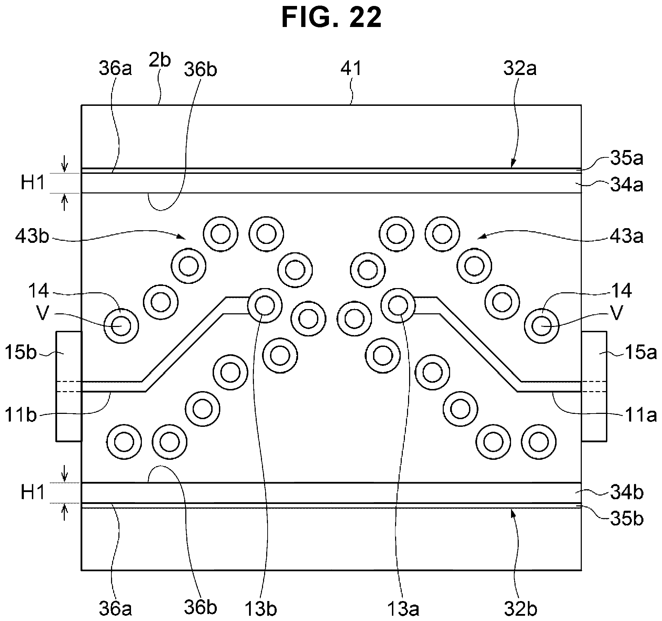

In the embodiments described above, a single metal-wall unit 32 is provided as the millimeter wave absorber and the built-in millimeter wave absorber in the multi-layer substrate 2b, but the present invention is not limited thereto, and two or more metal-wall units may be provided as the millimeter wave absorber and the built-in millimeter wave absorber in the multi-layer substrate 2b. For example, as shown in Fig. 22, two metal-wall units 32a and 32b facing each other may be provided in the multi-layer substrate 2b. The multi-layer substrate 2b is provided with a transmit port 43a and a receive port 43b.

In this case, as shown in Fig. 22, in a circuit substrate 41, the transmit port 43a and the receive port 43b are separated from each other at a predetermined interval and face each other. In the exemplary embodiment, the transmit port 43a and the receive port 43b are symmetrically disposed.

As for the transmit port 43a, a radio frequency integrated circuit 15a for transmission is provided on the edge portion of the multi-layer substrate 2b, and one end of a power feeder 11a for transmission is connected to the radio frequency integrated circuit 15a. A signal via 13a for transmission is provided at a predetermined position in the multi-layer substrate 2b so as to penetrate through the multi-layer substrate 2b in the thickness direction of the multi-layer substrate 2b, and is provided on the other end of the power feeder 11 for transmission.

As for the receive port 43b, a radio frequency integrated circuit 15b for reception is provided on the edge portion of the multi-layer substrate 2b, and one end of a power feeder 11b for reception is connected to the radio frequency integrated circuit 15b. In the multi-layer substrate 2b, a signal via 13b for reception is separated from the signal via 13a for transmission at a predetermined interval, penetrates through the multi-layer substrate 2b in the thickness direction of the multi-layer substrate 2b, and is provided on the other end of the power feeder 11b for reception.

In addition to such a configuration, in the multi-layer substrate 2b, a first metal-wall unit 32a and a second metal-wall unit 32b are disposed parallel to each other and penetrate through the multi-layer substrate 2b in the thickness direction of the multi-layer substrate 2b, and the transmit port 43a and the receive port 43b are provided between the first metal-wall unit 32a and the second metal-wall unit 32b which are disposed parallel to each other.

The metal-wall units 32a and 32b include wall portions 34a and 34b, respectively, having a wall shape and made of the same electromagnetic wave absorption material as that in the embodiments described above, and include metal walls 35a and 35b, respectively, having a wall shape provided on the first lateral faces 36a extending along a longitudinal direction of the wall portions 34a and 34b. As for the wall portions 34a and 34b, the metal walls 35a and 35b are not provided on the second lateral faces 36b on the side opposite to the first lateral faces 36a on which the metal walls 35a and 35b are provided, and thus, the second lateral faces 36b of the wall portions 34a and 34b are exposed in the multi-layer substrate 2b.

The transmit port 43a and the receive port 43b are provided between the second lateral face 36b of the wall portion 34a that is exposed in the multi-layer substrate 2b and the second lateral face 36b of the wall portion 34b that is also exposed in the multi-layer substrate 2b.

Relative permittivity and relative magnetic permeability of the electromagnetic wave absorption material of the wall portions 34a and 34b, and the thickness H1 of the wall portions 34a and 34b are adjusted such that the metal-wall units 32a and 32b allow a reflected wave reflected from the wall portions 34a and 34b and a reflected wave of an incident wave which is not absorbed by the wall portions 34a and 34b but is reflected from the metal walls 35a and 35b to interfere with and cancel out each other by impedance matching. This makes it possible for the metal-wall units 32a and 32b to absorb the unnecessary electromagnetic waves diffused from the power feeder 11a for transmission and the power feeder 11b for reception toward the metal-wall units 32a and 32b, thereby promptly reducing noise even further in the multi-layer substrate 2b.

### (9-2) <Simulation Test>

Next, Example 4 is directed to a simulated structure which defines the metal-wall units 32a and 32b facing each other, the transmit port 43a, the receive port 43b, and the like as shown in Fig. 22. A simulation test by the FDTD method and an electromagnetic field analysis are performed on the simulated structure of Example 4. In addition, Comparative Example 3 is directed to another simulated structure which defines the transmit port 43a and the receive port 43b surrounded by the metal vias V, excluding the metal-wall units 32a and 32b facing each other in the configuration of Example 4 shown in Fig. 22. The simulation test by the FDTD method and the electromagnetic field analysis are also performed on the simulated structure of Comparative Example 3.

As with the above-described simulation test, in this simulation test by the FDTD method, each via V is defined as a column-shaped structure having the via diameter H of 175 µm and the height of 644 µm. Each of the metal vias V and the metal walls 35a and 35 is a perfect conductor, and the wall portions 34a and 34b of the metal-wall units 32a and 32b have relative permittivity of 21.7 and relative magnetic permeability of 1.20. In Example 4, the thickness of the wall portion 34 is defined to be 175 µm, and the thickness of the metal wall 35 is defined to be 0 µm (that is, the metal wall 35 is defined as a metal surface without a thickness).

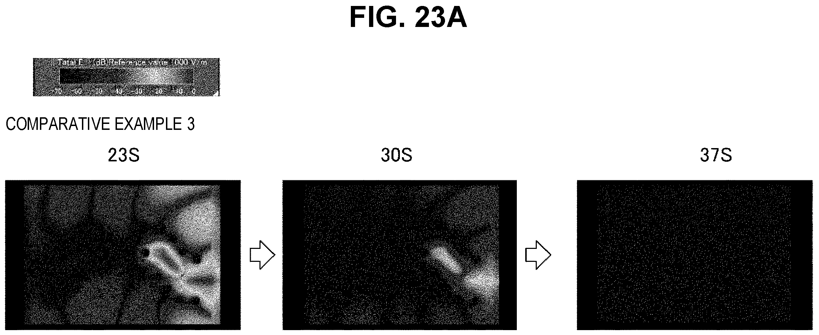

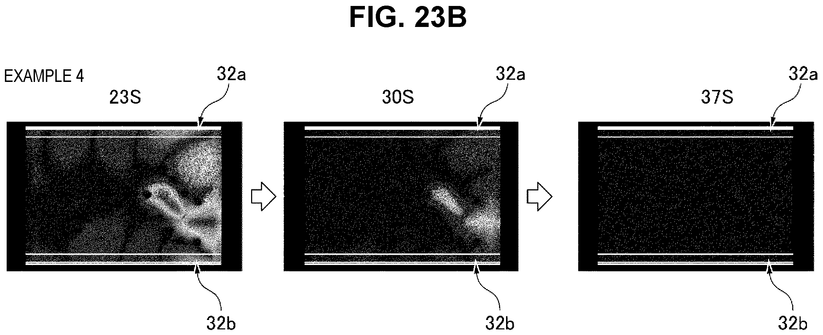

In Comparative Example 3 and Example 4, a pulsed wave having a peak in about 79 GHz band with the waveform shown in Fig. 18B is incident on the power feeder 11a for transmission, and the time dependence of the electric field intensity is measured. The measurement results in Comparative Example 3 are shown in Fig. 23A, and the measurement results in Example 4 are shown in Fig. 23B.

Fig. 23A and Fig. 23B show the electric field intensities in Comparative Example 3 and Example 4, respectively, when 23 s, 30 s, and 37 s have elapsed after the incidence of the pulsed wave, which has a peak in about 79 GHz band with the waveform shown in Fig. 18B, on the power feeder 11a for transmission.

As for Comparative Example 3 which does not define the metal-wall units 32a and 32b, Fig. 23A suggests that upon incidence of the pulsed wave on the power feeder 11a for transmission, the electromagnetic waves are widely diffused including an area around the receive port 43b. On the other hand, as for Example 4 which defines the metal-wall units 32a and 32b facing each other and the transmit port 43a and the receive port 43b, both of which are disposed between the metal-wall units 32a and 32b, Fig. 23B suggests that the unnecessary electromagnetic waves diffused in the multi-layer substrate 2b are absorbed by the metal-wall units 32a and 32b, and thus, the unnecessary electromagnetic waves in the multi-layer substrate 2b can be reduced.

### (10) <Another Embodiment of Metal-wall unit>

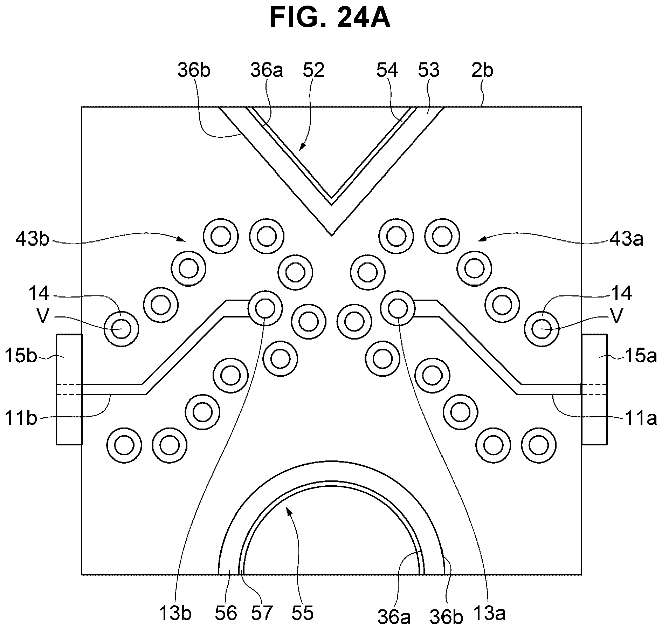

In the embodiments described above, the linearly extended metal-wall units 32, 32a, and 32b are provided as the millimeter wave absorber and the built-in millimeter wave absorber in the multi-layer substrate 2b, but the present invention is not limited thereto. As shown in Fig. 24A in which the same reference numerals are used to designate the same portions as those in Fig. 22, a V-shaped metal-wall unit 52 and an arc-shaped metal-wall unit 55 may be provided as the millimeter wave absorber and the built-in millimeter wave absorber in the multi-layer substrate 2b. In another embodiment, a metal-wall unit may have the shape of a circular ring, a quadrangle, a triangle, a wave, W, or other shapes. Alternatively, metal-wall units with different shapes may be combined and provided in the multi-layer substrate 2b.

In this case, the V-shaped metal-wall unit 52 includes a wall portion 53 having a wall shape and made of the same electromagnetic wave absorption material as that in the embodiments described above, and a metal wall 54 having a wall shape provided on the first lateral face 36a extending along a longitudinal direction of the wall portion 53. In the metal-wall unit 52, the second lateral face 36b of the wall portion 53 on which the metal wall 54 is not provided is disposed on the transmit port 43a side and the receive port 43b side, and the metal wall 54 faces the transmit port 43a and the receive port 43b across the wall portion 53.

The arc-shaped metal-wall unit 55 includes a wall portion 56 having a wall shape and made of the same electromagnetic wave absorption material as that in the embodiments described above, and a metal wall 57 having a wall shape provided on the first lateral face 36a extending along a longitudinal direction of the wall portion 56. In the metal-wall unit 55, the second lateral face 36b of the wall portion 56 on which the metal wall 57 is not provided is disposed on the transmit port 43a side and the receive port 43b side, and the metal wall 57 faces the transmit port 43a and the receive port 43b across the wall portion 56.

As with the embodiments described above, the metal-wall units 52 and 55 having the configuration described above are also able to absorb the unnecessary electromagnetic waves diffused from the power feeder 11a for transmission or the like toward the metal-wall units 52 and 55, and thus, noise in the multi-layer substrate 2b can be promptly reduced even further.

In the embodiments described above, the metal-wall units 32, 32a, 32b, 52, and 55 penetrate through the multi-layer substrate 2b in the thickness direction of the multi-layer substrate 2b, but the present invention is not limited thereto, and the metal-wall units 32, 32a, 32b, 52, and 55 do not necessarily penetrate through the multi-layer substrate 2b in the thickness direction.

The embodiments described above are directed to the metal-wall units 32, 32a, 32b, 52, and 55 including the metal walls 35, 35a, 35b, 54, and 57 on the first lateral faces 36a of the wall portions 34, 34a, 34b, 53, and 56, respectively, but the present invention is not limited thereto . In some cases, the wall portions 34, 34a, 34b, 53, and 56 may only be employed without the metal walls 35, 35a, 35b, 54, and 57.

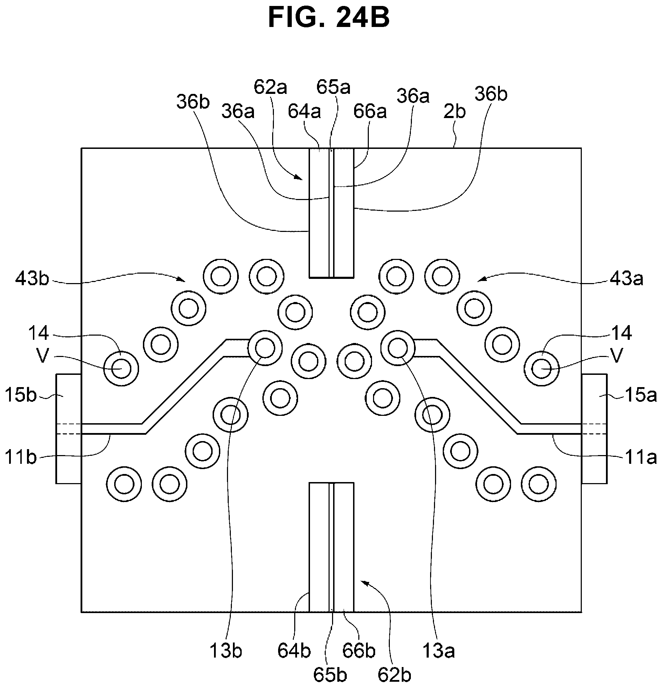

Other metal-wall units can also be employed as the millimeter wave absorber and built-in millimeter wave absorber for a circuit substrate. As shown in Fig. 24B in which the same reference numerals are used to designate the same portions as those in Fig. 22, a metal-wall unit 62a can be employed which includes a metal wall 65a having a wall shape and wall portions 64a and 66a on both sides of the metal wall 65a in the multi-layer substrate 2b, the wall portions 64a and 66a having a wall shape and being made of the same electromagnetic wave absorption material as that in the embodiments described above.

In Fig. 24B, as an example, two metal-wall units 62a and 62b are disposed in series between the transmit port 43a and the receive port 43b to avoid a region between the signal via 13a of the transmit port 43a and the signal via 13b of the receive port 43b.

In Fig. 24B, for example, a region between the signal via 13a of the transmit port 43a and the signal via 13b of the receive port 43b is relatively small, and the metal-wall unit 62a cannot be disposed between the signal via 13a of the transmit port 43a and the signal via 13b of the receive port 43b. Therefore, the metal-wall units 62a and 62b are provided so as to avoid the region between the signal via 13a of the transmit port 43a and the signal via 13b of the receive port 43b.

Here, the metal-wall units 62a and 62b have the same configuration, and thus, the following explanation will focus on one metal-wall unit 62a. The metal-wall unit 62a includes the wall portions 64a and 66a having a wall shape and made of the same electromagnetic wave absorption material as that in the embodiments described above, and the metal wall 65a that has a wall shape, extends along a longitudinal direction of the wall portions 64a and 66a and is disposed between the wall portions 64a and 66a which are placed parallel to each other.

In this case, each of the wall portions 64a and 66a has the first lateral face 36a on which the metal wall 65a is provided, and the second lateral face 36b which is on the side opposite to the first lateral face and on which the metal wall 65a is not provided, and thus, the second lateral face 36b is exposed in the multi-layer substrate 2b. In the metal-wall unit 62a, the second lateral face 36b of the wall portion 64a is disposed on the receive port 43b side, and the second lateral face 36b of the wall portion 66a is disposed on the transmit port 43a side so that the metal wall 65a faces the transmit port 43a and the receive port 43b across the wall portions 64a and 66a.

In the metal-wall units 62a and 62b having the configurations described above, the unnecessary electromagnetic waves diffused from the power feeder 11a for transmission toward the metal-wall units 52 and 55 are absorbed mainly by the wall portions 66a and 66b, while the unnecessary electromagnetic waves diffused from the power feeder 11b for reception toward the metal-wall units 62a and 62b are absorbed mainly by the wall portions 66a and 66b, and thus, noise in the multi-layer substrate 2b can be promptly reduced even further.

### Reference Sign List

1: Antenna element
2: Circuit substrate
2a: Base substrate
2b: Multi-layer substrate
2e: Dielectric layer
4: Receiving antenna (antenna)
5: Transmitting antenna (antenna)
7a: Power feeder for reception (power feeder)
7b: Power feeder for transmission (power feeder)
Va, Vb, Vc, V₁ to V₁₂, V₃₅ to V₄₁: Shield via (millimeter wave absorber, built-in millimeter wave absorber)
V₂₁ to V₃₂: Metal-wall shield via (millimeter wave absorber, built-in millimeter wave absorber)
2b₆: Shield layer (millimeter wave absorber, built-in millimeter wave absorber)
32, 32a, 32b, 52, 55, 62a, 62b: Metal-wall unit (millimeter wave absorber, built-in millimeter wave absorber)

## Claims

1. A circuit substrate, comprising:
a multi-layer substrate in which a plurality of dielectric layers are stacked; and
a millimeter wave absorber provided inside the multi-layer substrate and having an electromagnetic wave absorption peak within a region of 30 to 300 GHz.

2. The circuit substrate according to claim 1, wherein
the millimeter wave absorber is a pillar-shaped shield via provided in a thickness direction of the multi-layer substrate.

3. The circuit substrate according to claim 1, wherein
the millimeter wave absorber includes:
an absorption portion having an electromagnetic wave absorption peak within a region of 30 to 300 GHz; and
a reflection portion made of a metal material, wherein
the millimeter wave absorber is configured to allow a reflected wave of an electromagnetic wave that is reflected from the absorption portion and a reflected wave of the electromagnetic wave that is reflected from the reflection portion to interfere with and cancel out each other by impedance matching.

4. The circuit substrate according to claim 1, wherein
the millimeter wave absorber is a metal-wall shield via including:
a pillar portion provided in a thickness direction of the multi-layer substrate and having an electromagnetic wave absorption peak within a region of 30 to 300 GHz; and
a metal wall provided on an outer circumferential wall of the pillar portion to cover one-third or more and two-thirds or less of a circumference of the pillar portion.

5. The circuit substrate according to claim 4, wherein
the metal-wall shield via is configured to allow a reflected wave of an electromagnetic wave that is reflected from the pillar portion and a reflected wave of the electromagnetic wave that is reflected from the metal wall to interfere with and cancel out each other by impedance matching.

6. The circuit substrate according to claim 4 or 5, wherein
the metal wall of the metal-wall shield via has an inner circumferential wall which faces a power feeder across the pillar portion.

7. The circuit substrate according to claim 2, wherein
the shield via includes:
a first pillar portion having an electromagnetic wave absorption peak within a region of 30 to 300 GHz; and
a second pillar portion made of a metal material, wherein
the first pillar portion and the second pillar portion are alternately stacked to provide a pillar-shaped shield via.

8. The circuit substrate according to claim 2, wherein
the shield via includes:
a first half body portion having a half pillar shape and having an electromagnetic wave absorption peak within a region of 30 to 300 GHz; and
a second half body portion having a half pillar shape and made of a metal material, wherein
the first half body portion and the second half body portion are joined to provide a pillar-shaped shield via.

9. The circuit substrate according to claim 1, wherein
the millimeter wave absorber is a shield layer provided along an in-plane direction of the multi-layer substrate.

10. The circuit substrate according to claim 1, wherein
the millimeter wave absorber includes a wall portion provided inside the multi-layer substrate.

11. The circuit substrate according to claim 10, wherein
the millimeter wave absorber is a metal-wall unit including the wall portion and a metal wall provided on the wall portion, wherein
the millimeter wave absorber is configured to allow a reflected wave of an electromagnetic wave that is reflected from the wall portion and a reflected wave of the electromagnetic wave that is reflected from the metal wall to interfere with and cancel out each other by impedance matching.

12. The circuit substrate according to any one of claims 1 to 11, wherein
the millimeter wave absorber is made of a mixture of a magnetic material for adjusting relative permittivity and a magnetic material for adjusting relative magnetic permeability.

13. The circuit substrate according to any one of claims 1 to 12, wherein
the millimeter wave absorber contains epsilon-type iron oxide as a magnetically permeable material.

14. An antenna element, comprising:
the circuit substrate according to any one of claims 1 to 13;
a power feeder provided inside the multi-layer substrate of the circuit substrate; and
an antenna provided on a surface of the circuit substrate and connected to the power feeder.

15. The antenna element according to claim 14, wherein
a plurality of millimeter wave absorbers are provided along the power feeder inside the circuit substrate.

16. A built-in millimeter wave absorber for a circuit substrate, the built-in millimeter wave absorber being provided inside a multi-layer substrate in which a plurality of dielectric layers are stacked, and having an electromagnetic wave absorption peak within a region of 30 to 300 GHz.

17. A method for reducing noise in a circuit substrate including a multi-layer substrate in which a plurality of dielectric layers are stacked, the method comprising:
by a millimeter wave absorber provided inside the multi-layer substrate and having an electromagnetic wave absorption peak within a region of 30 to 300 GHz, absorbing unnecessary electromagnetic waves diffused in the multi-layer substrate to reduce noise in the circuit substrate.
